(19) Europäisches Patentamt
European Patent Office
Office européen des brevets

(11) **EP 2 800 149 A1**

(12) **EUROPEAN PATENT APPLICATION**
published in accordance with Art. 153(4) EPC

(43) Date of publication:
**05.11.2014 Bulletin 2014/45**

(51) Int Cl.:
*H01L 31/042* [(2014.01)]    *B32B 27/00* [(2006.01)]

(21) Application number: **12863019.1**

(86) International application number:
**PCT/JP2012/083997**

(22) Date of filing: **27.12.2012**

(87) International publication number:
**WO 2013/100108 (04.07.2013 Gazette 2013/27)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **28.12.2011   JP 2011290036**
**13.12.2012   JP 2012272837**
**13.12.2012   JP 2012272839**
**13.12.2012   JP 2012272841**

(71) Applicant: **Mitsubishi Plastics, Inc.**
**Tokyo 100-8252 (JP)**

(72) Inventors:
• **NINOMIYA, Naoya**
**Ushiku-shi**
**Ibaraki 300-1201 (JP)**

• **AYA, Tetsuya**
**Ushiku-shi**
**Ibaraki 300-1201 (JP)**
• **AKAIKE, Osamu**
**Ushiku-shi**
**Ibaraki 300-1201 (JP)**
• **KUDOU, Hirofumi**
**Ushiku-shi**
**Ibaraki 300-1201 (JP)**
• **MITSUKURA, Yumi**
**Ushiku-shi**
**Ibaraki 300-1201 (JP)**

(74) Representative: **Merkle, Gebhard**
**Ter Meer Steinmeister & Partner**
**Mauerkircherstrasse 45**
**81679 München (DE)**

(54) **PROTECTIVE MATERIAL FOR SOLAR CELLS**

(57)    The present invention achieves a solar cell protective material containing a moisture-resistant film with a moisture vapor permeability of less than 0.1 g/m$^2$/day, but not decreasing the moisture resistance for a long term, preventing delamination, and having excellent flexibility and excellent moisture resistance. The present invention provides a solar cell protective material having an effect in preventing the performance degradation of a solar cell and improving the durability of a solar cell. The solar cell protective material includes a fluorine-based resin film; a pressure sensitive adhesive layer; and a moisture-resistant film having a base material and an inorganic layer on at least one side of the base material, the moisture-resistant film having a moisture vapor permeability of less than 0.1 g/m$^2$/day, in which the fluorine-based resin film, the pressure sensitive adhesive layer, and the moisture-resistant film are laminated as a protective material-forming layer P, and the ratio ($W_P/W_A$) of the maximum width $W_P$ of the protective material-forming layer P other than the fluorine-based resin film to the width $W_A$ of the fluorine-based resin film is less than 1.

Fig. 2

## Description

Technical Field

The present invention relates to a protective material used for a solar cell and the like. Particularly, the present invention relates to a protective material for solar cells (a solar cell protective material) capable of maintaining the moisture resistance and preventing delamination.

Background Art

In recent years, solar cells directly converting sunlight into electric energy has been drawing attention and developed from the aspect of efficient use of resources, the prevention of environmental pollution, and the like. The solar cell is formed by sealing a solar cell between a front protective sheet (hereinafter sometimes referred to as "front sheet") and a back protective sheet (hereinafter sometimes referred to as "back sheet") with a sealing film such as an ethylene-vinyl acetate copolymer film, a polyethylene film, or a polypropylene film.
Such a solar cell is typically produced by laminating a front protective film, an encapsulating material, an electric power generating device, an encapsulating material, and a back protective film in the stated order and integrating these layers by melting and adhering. A solar cell protective material as the front protective sheet or the back protective sheet of a solar cell is required to have excellent durability to ultraviolet rays. Additionally, a solar cell protective material is extremely significantly required to have excellent moisture resistance to prevent the internal lead and the electrode from rusting caused by the penetration of moisture and the like. Furthermore, an excellent protective material with slightly decrease in the moisture resistance under the long-term use and the high temperature condition is desired to be developed.
For example, Patent document 1 describes that a solar cell protective material is produced by attaching a weather-resistant polyester film and a polypropylene film to the deposited inorganic side and the other side of a moisture-resistant film containing a biaxially-oriented polyester film as the base material and having a moisture vapor permeability of 0.22 $g/m^2/day$, respectively, by using a polyester adhesive. Patent document 1 also describes that the solar cell protective material is evaluated after 1000 hour test under a temperature of 85 °C and a humidity of 85% to show that the moisture resistance is prevented from decreasing.
An example of Patent document 2 describes that a solar cell protective material is produced by providing a polyurethane adhesive layer on the both sides of a moisture-resistant film containing a biaxially-oriented polyester film as the base material and having a moisture vapor permeability of 1 to 2 $g/m^2/day$ and by laminating a weather-resistant polyester film to the both polyurethane adhesive layers. Patent document 2 also describes that the solar cell protective material is evaluated after 1000 hour accelerated test under humidity 85 °C and 85% to show that the barrier performance and the interlaminar strength are prevented from decreasing.
Patent document 3 described that a solar cell protective material is produced by attaching a PVF film to a moisture-resistant film containing a biaxially-oriented polyester film as the base material and having a moisture vapor permeability of 0.5 $g/m^2/day$ by using a two-component curing type polyurethane-based adhesive. Patent document 2 also describes that the solar cell protective material is evaluated before and after high pressure cooker test (PCT) (severe environmental test under high temperature and pressure, in this case, at 105 °C for 92 hours) to show that the barrier performance and the interlaminar strength are prevented from decreasing.

Citation List

Patent Literature

    Patent document 1: JP 2007-150084A
    Patent document 2: JP 2009-188072A
    Patent document 3: JP 2009-49252A

Summary of Invention

Technical Problem

The technology disclosed in Patent documents 1 to 3 relates to a laminate having a moisture-resistant film with a moisture vapor permeability of 0.1 $g/m^2/day$ or more. However, a solar cell protective material and the like of a solar cell module and the like formed of a compound-type power-generating device are required to have a higher moisture resistance. When the above-mentioned laminate is applied to such a solar cell protective material and the like, the moisture resistance cannot be sufficiently maintained for a long term, or the delamination cannot be sufficiently prevented at the end faces of the protective material, under severe environment substituted by accelerated endurance test of the above-mentioned pressure cooker test (PCT) or the like.

A solar cell protective material is desired to maintain excellent moisture resistance and substantially prevent delamination for a long term. However, a solar cell protective material capable of maintaining the moisture resistance and preventing the delamination for a long term has not been specifically suggested when a high moisture-resistant film having a moisture vapor permeability of less than 0.1 $g/m^2/day$ is used.

An objective of the present invention is to achieve a solar cell protective material containing a moisture-resistant film with a moisture vapor permeability of less than 0.1 $g/m^2/day$, but not decreasing the moisture resistance for a long term, preventing delamination, and having excellent flexibility and excellent moisture resistance. Another objective of the present invention is to provide a solar cell protective material having an effect in preventing the performance degradation of a solar cell and improving the durability of a solar cell.

Solution to Problem

As a result of their extensive study, the inventors found that a solar cell protective material including a fluorine-based resin film; a pressure sensitive adhesive layer; and a moisture-resistant film having a base material and an inorganic layer on at least one side of the base material, the moisture-resistant film having a moisture vapor permeability of less than 0.1 $g/m^2/day$, in which the fluorine-based resin film, the pressure sensitive adhesive layer, and the moisture-resistant film are laminated as a protective material-forming layer P, and the ratio ($W_P/W_A$) of the maximum width $W_P$ of the protective material-forming layer P other than the fluorine-based resin film to the width $W_A$ of the fluorine-based resin film is less than 1, prevents the decrease of the moisture resistance and the delamination from occurring after laminated to an encapsulating material. Then, the inventors achieved the present invention.

According to the present invention,

[1] A solar cell protective material includes a fluorine-based resin film; a pressure sensitive adhesive layer; and a moisture-resistant film having a base material and an inorganic layer on at least one side of the base material, the moisture-resistant film having a moisture vapor permeability of less than 0.1 $g/m^2/day$, in which the fluorine-based resin film, the pressure sensitive adhesive layer, and the moisture-resistant film are laminated as a protective material-forming layer P, and the ratio ($W_P/W_A$) of the maximum width $W_P$ of the protective material-forming layer P other than the fluorine-based resin film to the width $W_A$ of the fluorine-based resin film is less than 1.

[2] In the solar cell protective material according to [1], $W_P/W_A$ is 0.7 to 0.98.

[3] In the solar cell protective material according to [1] or [2], the layer having the maximum width of the protective material-forming layer P other than the fluorine-based resin film is the moisture-resistant film.

[4]In the solar cell protective material according to any one of [1] to [3], the pressure sensitive adhesive layer has a tensile storage elastic modulus of $5.0 \times 10^4$ to $5.0 \times 10^5$ Pa at a temperature of 100 °C, a frequency of 10 Hz, and a strain of 0.1% and also has a thickness of 13 $\mu$m or more.

[5] In the solar cell protective material according to any one of [1] to [4], the thickness of the base material is 25 to 250 $\mu$m.

[6] In the solar cell protective material according to any one of [1] to [5], the inorganic layer side of the moisture-resistant film is laminated to the fluorine-based resin film.

[7] An encapsulating material-integrated protective material is formed by further laminating an encapsulating material layer to the moisture-resistant film side of the solar cell protective material according to any one of [1] to [6].

[8] In the encapsulating material-integrated protective material according to [7], the width $W_D$ of the encapsulating material layer is less than the width $W_A$ of the fluorine-based resin film and more than the maximum width $W_P$ of the protective material-forming layer P other than the fluorine-based resin film.

[9] A roll-shaped article is formed by rolling up the solar cell protective material according to any one of [1] to [6] or the encapsulating material-integrated protective material according to [7] or [8].

[10] A roll-shaped article with a cover sheet is formed by at least partially covering a part at which the fluorine-based resin film projects from the surface of the roll-shaped article according to [9] with a cover sheet having a deflection length of 70 mm or less and a load bearing dent of 0.1 or less, in which the deflection length is measured in a condition in which

(1) a sample with a width of 20 mm and a length of 120 mm is collected,
(2) the sample is placed on and protruded from a platform so that the protuberance from the platform has a length of 100 mm , and then a 5 kg weight is added on the part of the sample on the platform to fix the sample, and
(3) how much the end of the part of the sample being protruded from the platform hangs down from the platform is measured, and this measured length x (unit: mm) is determined as the deflection length, and
the load bearing dent is measured in a condition in which

(1) a 100 mm square sample is collected,
(2) the sample is placed on a glass plate with a thickness of 20 mm, a 0.5 g steel ball with a diameter of 5 mm is added on the central part of the sample, and a 2 kg load is further added on the steel ball,
(3) the dent "d" in the sample (unit: $\mu$m) is measured, and the ratio "d/t" of the dent "d" to the thickness "t" (unit: $\mu$m) of the sample is determined as the load bearing dent.

[11] In the roll-shaped article according to [10], the conditions (a') and/or (b') are satisfied,
the condition (a') is deflection length of cover sheet / deflection length of fluorine-based resin film $\leq$ 2, and
the condition (b') is load bearing dent of cover sheet / load bearing dent of fluorine-based resin film $\leq$ 2.
[12] A method of producing a solar cell protective material includes the steps of:

(1) forming a laminate X having a pressure sensitive adhesive layer on a moisture-resistant film;
(2) slitting both the ends in the width direction of the laminate X to form a laminate X'; and
(3) attaching a fluorine-based resin film having a width $W_A$ being more than the width $W_{X'}$ of the laminate X' to the pressure sensitive adhesive layer so that both the ends of the fluorine-based resin film project from the respectively corresponding ends of the pressure sensitive adhesive layer.

[13] In the method according to [12], a laminate X further having a release sheet 1 is formed on the pressure sensitive adhesive layer in the step (1), and the release sheet 1 is peeled off after the step (2) and before the fluorine-based resin film is attached.
[14] In the method according to [13], in the step (1), a pressure sensitive adhesive layer composition is applied to a release sheet 1 and dried to form a pressure sensitive adhesive layer, and then a moisture-resistant film is attached to the pressure sensitive adhesive layer to form a laminate X.
[15] A solar cell module is formed by using the solar cell protective material according to any one of [1] to [6] or the encapsulating material-integrated protective material according to [7] or [8].

Advantageous Effects of Invention

The present invention provides a solar cell protective material having excellent flexibility and excellent moisture resistance with no decrease in the moisture resistance and no delamination in the use under high temperature and high humidity for a long term and having an effect in preventing the performance degradation of a solar cell and in improving the durability of a solar cell. The solar cell protective material of the present invention has excellent flexibility and excellent moisture resistance with no decrease in the moisture resistance and the interlaminar strength even after subjected to heat treatment under high temperature environment, specifically, under the condition of thermal lamination.

Brief Description of Drawings

FIG. 1 shows a sectional view illustrating an embodiment of the solar cell protective material of the present invention.
FIG. 2 shows a sectional view illustrating an example of use of the solar cell protective material of the present invention.
FIG. 3 shows a diagram illustrating the evaluation method of the deflection length.
FIG. 4 shows a diagram illustrating the evaluation method of the load bearing dent.
FIG. 5 shows a diagram illustrating an embodiment of the method of producing the solar cell protective material of the present invention.
FIG. 6 shows a sectional view illustrating an example of the solar cell protective material obtained by a conventional method of producing a solar cell protective material.

Description of Embodiments

The present invention will be explained in more detail below. The solar cell protective material can prevent moisture from being infiltrated from the exposed face of the film because a moisture-resistant film is laminated. In the long-term use substituted by accelerated test under high-temperature and high-humidity environment, the moisture infiltration from the end faces of the solar cell protective material gradually deteriorates the adhesive used for laminating films and the base material of the moisture-resistant film so that the delamination or the decrease of the moisture resistance performance may occur from the end faces.

Particularly, the moisture-resistant film with a moisture resistance of about less than 0.1 $g/m^2/day$ is significantly affected by the decrease of the moisture resistance due to the shrinkage of the film and by the moisture infiltration from the end faces. This is because a minor defect in the inside of the inorganic layer of the moisture-resistant film and the interface between the base material and the inorganic layer, deterioration caused by the hydrolysis of the base material, and the like significantly affect the moisture resistance.

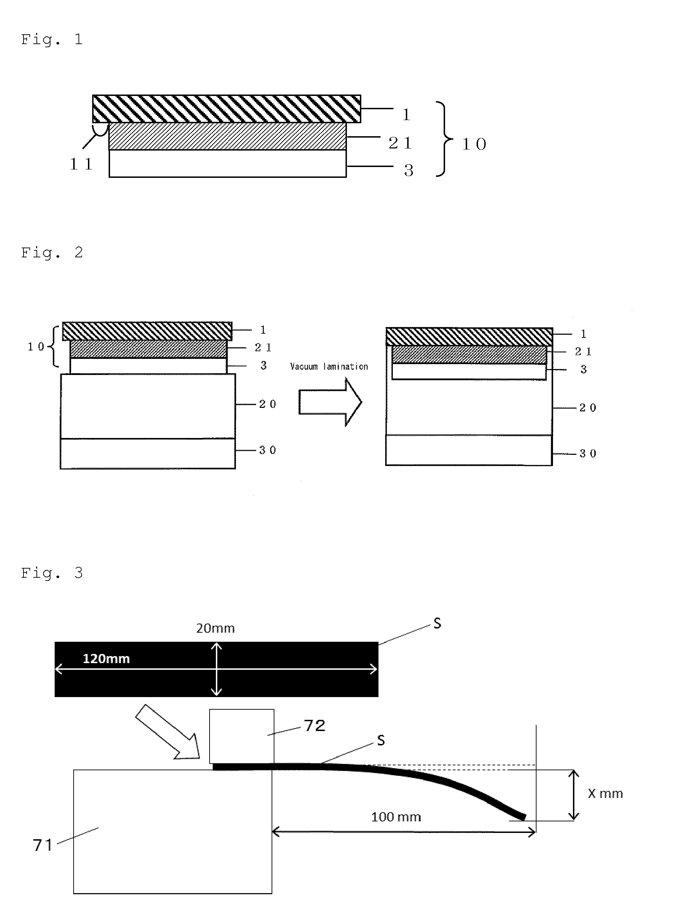

Accordingly, the inventors found that a solar cell protective material including a fluorine-based resin film; a pressure sensitive adhesive layer; and a moisture-resistant film having a base material and an inorganic layer on at least one side of the base material, the moisture-resistant film having a moisture vapor permeability of less than 0.1 $g/m^2/day$, in which the fluorine-based resin film, the pressure sensitive adhesive layer, and the moisture-resistant film are laminated as a protective material-forming layer P, the width P of protective material-forming layer including a moisture-resistant film other than the fluorine-based resin film is less than the width of the fluorine-based resin film prevents the decrease of the moisture resistance and the delamination from the end faces from the effect of an encapsulating material (20) on a solar cell (30) wrapped around the end faces of the pressure sensitive adhesive layer (21) and the moisture-resistant film (3). The pressure sensitive adhesive layer and the moisture-resistant film have a smaller width than the fluorine-based resin film (1) to encapsulate these end faces in vacuum lamination as shown in FIG.2.

Specifically, the present invention relates to a solar cell protective material (10) includes a fluorine-based resin film (1); a pressure sensitive adhesive layer (21); and a moisture-resistant film (3) having a base material and an inorganic layer on at least one side of the base material, the moisture-resistant film having a moisture vapor permeability of less than 0.1 $g/m^2/day$, in which the fluorine-based resin film, the pressure sensitive adhesive layer, and the moisture-resistant film are laminated as a protective material-forming layer P, and the ratio ($W_P/W_A$) of the maximum width $W_P$ of the protective material-forming layer P other than the fluorine-based resin film to the width $W_A$ of the fluorine-based resin film is less than 1.

Solar cell protective material

Fluorine-based resin film

The solar cell protective material of the present invention has hydrolysis resistance and weather resistance, which is provided with a fluorine-based resin film to impart long-term durability.

The fluorine-based resin film preferably has weather resistance. As the fluorine-based resin, for example, polytetrafluoroethylene (PTFE), a tetrafluoroethylene-perfluoroalkyl vinyl ether copolymer (PFA), a tetrafluoroethylene-hexafluoropropylene copolymer (FEP), a tetrafluoroethylene-ethylene copolymer (ETFE), polychlorotrifluoroethylene (PCTFE), polyvinylidenefluoride (PVDF), polyvinyl fluoride (PVF), and the like are preferably used.

From the viewpoint of the long-term durability, tetrafluoroethylene-ethylene copolymer (ETFE) and tetrafluoroethylene-hexafluoropropylene copolymer (FEP) are more preferably used as the above-mentioned fluorine-based resin.

The properties of the fluorine-based resin film preferably slightly change in vacuum lamination and in the change of temperature and humidity. Therefore, for a fluorine-based film with a large shrinkage rate, the shrinkage rate is preferably reduced by a previous heat treatment.

If the ratio ($W_P/W_A$) of the maximum width $W_P$ of the protective material-forming layer P other than the fluorine-based resin film to the width $W_A$ of the fluorine-based resin film is 1 or more, the thickness of the encapsulating material wrapped around the end faces is reduced to cause delamination. Thus, $W_P/W_A$ should be less than 1. If the difference between $W_A$ and $W_P$ is too much, the encapsulating material may be insufficiently wrapped around the end faces, or the thickness of the laminate may not be homogeneously maintained after vacuum lamination. Therefore, $W_P/W_A$ is preferably 0.7 to 0.98. To more stably prevent delamination, $W_P/W_A$ is more preferably 0.75 to 0.95, further more preferably 0.8 to 0.92. As long as $W_P/W_A$ is less than 1, how much $W_A$ is increased in right and left directions to $W_P$ may be optional. However, $W_A$ is preferably increased evenly in right and left directions. In the present invention, "the width of a film" means the length in the lateral direction to the longitudinal direction of a winded off film when the protective material is provided in a roll shape and the length of the short side of a film when the protective material is provided in a sheet shape.

Various additives can optionally be added to the fluorine-based resin film. Examples of the additive include an ultraviolet absorber, a weather-resistant stabilizer, an antioxidant, an antistat, and an anti-blocking agent but are not limited thereto.

The thickness of the fluorine-based resin film is generally about 20 to 200 $\mu$m. From the viewpoint of the handleability and the cost of the film, the thickness is preferably 20 to 100 $\mu$m, more preferably 20 to 60 $\mu$m.

Moisture-resistant film

In the present invention, the moisture-resistant film has a base material and an inorganic layer formed on at least one side of the base material and has a moisture vapor permeability of less than 0.1 g/m$^2$/day. Since the solar cell protective material of the present invention is desired to maintain a high moisture resistance for a long term, the initial moisture resistance should be more than a certain level. Therefore, in the present invention, the above-mentioned moisture-resistant film has a moisture vapor permeability of less than 0.1 g/m$^2$/day, preferably 0.05 g/m$^2$/day or less, more preferably 0.03 g/m$^2$/day or less. Moreover, the moisture-resistant film is preferably transparent when the solar cell protective material is used as the front sheet used for the sunlight-receiving side.

The thickness of the moisture-resistant film is generally 5 to 300 $\mu$m. From the viewpoint of the curl suppression, the withstand voltage, the cushioning properties, the productivity, and the handleability of the solar cell protective material, the thickness of the moisture-resistant film is preferably 25 to 250 $\mu$m, more preferably 38 to 200 $\mu$m, further more preferably 50 to 180 $\mu$m.

Base material

The base material of the above-mentioned moisture-resistant film is preferably a resin film. Any materials can be used for the base material without any limitation in particular as long as being resins usable for a typical solar cell material.

Specifically, examples of the material of the base material include a polyolefin such as a homopolymer or a copolymer of ethylene, propylene, butene, and the like; an amorphous polyolefin such as a cyclic polyolefin; polyesters such as a polyethylene terephthalate (PET) and a polyethylene naphthalate (PEN); polyamides such as nylon 6, nylon 66, nylon 12, and a copolymerized nylon; and an ethylene-vinyl acetate copolymer partial hydrolysate (EVOH), a polyimide, a polyetherimide, a polysulfone, a polyether sulfone, a polyether ether ketone, a polycarbonate, a polyvinyl butyral, a polyarylate, a fluorine resin, an acrylic resin, and a biodegradable resin. Particularly, the material of the base material is preferably a thermoplastic resin. From the viewpoint of the film properties, the cost, and the like, the material of the base material is more preferably a polyester, a polyamide, and a polyolefin. From the viewpoint of the surface smoothness, the film strength, the heat resistance, and the like, the material of the base material is particularly preferably a polyethylene terephthalate (PET) and a polyethylene naphthalate (PEN).

Various additives can optionally be added to the above-mentioned base material. Examples of the additive include an antistat, an ultraviolet absorber, a plasticizer, a lubricant, a filler, a colorant, a weather-resistant stabilizer, an anti-blocking agent, and an antioxidant but are not limited thereto.

Examples of the usable UV absorber include various types such as benzophenone-based, benzotriazole-based, triazine-based, and salicylic acid ester-based types. Thus, various commercially available products are applicable to the UV absorber.

Examples of the benzophenone-based ultraviolet absorber
include 2-hydroxy-4-methoxybenzophenone,
2-hydroxy-4-methoxy-2'-carboxybenzophenone,
2-hydroxy-4-octoxybenzophenone,
2-hydroxy-4-n-dodecyloxybenzophenone,
2-hydroxy-4-n-octadecyloxybenzophenone,

2-hydroxy-4-benzyloxybenzophenone,
2-hydroxy-4-methoxy-5-sulfobenzophenone,
2-hydroxy-5-chlorobenzophenone, 2,4-dihydroxybenzophenone,
2,2'-dihydroxy-4-methoxybenzophenone,
2,2'-dihydroxy-4,4'-dimethoxybenzophenone, and
2,2',4,4'-tetrahydroxybenzophenone.

The benzotriazole-based ultraviolet absorber is a hydroxyphenyl-substituted benzotriazole compound, the examples of which include
2-(2-hydroxy-5-methylphenyl)benzotriazole, 2-(2-hydroxy-5-t-butylphenyl)benzotriazole,
2-(2-hydroxy-3,5-dimethylphenyl)benzotriazole,
2-(2-methyl-4-hydroxyphenyl)benzotriazole,
2-(2-hydroxy-3-methyl-5-t-butylphenyl)benzotriazole,
2-(2-hydroxy-3,5-di-t-amylphenyl)benzotriazole, and
2-(2-hydroxy-3,5-di-t-butylphenyl)benzotriazole.

In addition, examples of the triazine-based UV absorber include 2-[4,6-bis(2,4-dimethylphenyl)-1,3,5-triazin-2-yl]-5-(octy loxy)phenol and 2-(4,6-diphenyl-1,3,5-triazin-2-yl)-5-(hexyloxy)phenol.

Examples of the salicylic acid ester-based UV absorber include phenyl salicylate and p-octylphenyl salicylate.

The content of the ultraviolet absorber in the base material is typically about 0.01 to 2.0% by mass, preferably 0.05 to 0.5 % by mass.

A hindered amine-based light stabilizer can be used as the weather-resistant stabilizer imparting weather resistance except the above-mentioned UV absorber. The hindered amine-based light stabilizer does not absorb ultraviolet light unlike the UV absorber, but shows a significant synergistic effect when used in combination with the UV absorber.

Examples of the hindered amine-based light stabilizer include a dimethyl succinate-1-(2-hydroxyethyl)-4-hydroxy-2,2,6,6-tetramethyl piperidine polycondensation product, poly[{6-(1,1,3,3-tetramethylbutyl)amino-1,3,5-triazine-2,4   -diyl}{(2,2,6,6-tetramethyl-4-piperidyl)imino}hexamethylen e{{2,2,6,6-tetramethyl-4-piperidyl}imino}], an N,N'-bis(3-aminopropyl)ethylenediamine-2,4-bis[N-butyl-N-( 1,2,2,6,6-pentamethyl-4-piperidyl)amino]-6-chloro-1,3,5-tr iazine condensation product, bis(2,2,6,6-tetramethyl-4-piperidyl) sebacate, and bis(1,2,2,6,6-pentamethyl-4-piperidyl) 2-(3,5-di-tert-butyl-4-hydroxybenzyl)-2-n-butylmalonate. The content of the hindered amine-based light stabilizer in the base material is typically about 0.01 to 0.5% by mass, preferably 0.05 to 0.3 % by mass.

Various commercially available products can be used as the antioxidant, and examples thereof include antioxidants of various types such as monophenol-based, bisphenol-based, high molecular weight phenol-based, sulfur-based, and phosphite-based types. Examples of the monophenol-based antioxidant include 2,6-di-tert-butyl-p-cresol, butylated hydroxyanisole, and 2,6-di-tert-butyl-4-ethylphenol. Examples of the bisphenol-based antioxidant include 2,2'-methylene-bis-(4-methyl-6-tert-butylphenol), 2,2'-methylene-bis-(4-ethyl-6-tert-butylphenol), 4,4'-thiobis-(3-methyl-6-tert-butylphenol), 4,4'-butylidene-bis-(3-methyl-6-tert-butylphenol), and 3,9-bis[{1,1-dimethyl-2-{β-(3-tert-butyl-4-hy droxy-5-methy lphenyl)propionyloxy}ethyl}2,4,9,10-tetraoxaspiro]5,5-unde cane.

Examples of the high molecular weight phenol-based antioxidant include 1,1,3-tris-(2-methyl-4-hydroxy-5-tert-butylphenyl)butane, 1,3,5-trimethyl-2,4,6-tris(3,5-di-tert-butyl-4-hydroxybenz yl)benzene, tetrakis-{methylene-3-(3',5'-di-tert-butyl-4'-hydroxypheny l)propionate}methane, bis{(3,3'-bis-4'-hydroxy-3'-tert-butylphenyl)butyric acid} glycol ester, 1,3,5-tris(3',5'-di-tert-butyl-4'-hydroxybenzyl)-s-triazin e-2,4,6-(1H,3H,5H)trione, and triphenol (vitamin E).

Examples of the sulfur-based antioxidant include dilauryl thiodipropionate, dimyristyl thiodipropionate, and distearyl thiodipropionate.

Examples of the phosphite-based antioxidant include triphenyl phosphite, diphenyl isodecyl phosphite, phenyl diisodecyl phosphite, 4,4'-butylidene-bis(3-methyl-6-tert-butylphenyl-di-tridecy 1) phosphite, cyclic neopentanetetrayl bis(octadecyl phosphite), tris(mono and/or di)phenyl phosphite, diisodecyl pentaerythritol diphosphite, 9,10-dihydro-9-oxa-10-phosphaphenanthrene-10-oxide, 10-(3,5-di-tert-butyl-4-hydroxybenzyl)-9,10-dihydro-9-oxa-10-phosphaphenanthrene-10-oxide, 10-decyloxy-9,10-dihydro-9-oxa-10-phosphaphenanthrene, cyclic neopentanetetrayl bis(2,4-di-tert-butylphenyl) phosphite, cyclic neopentanetetrayl bis(2,6-di-tert-methylphenyl) phosphite, and 2,2-methylenebis(4,6-tert-butylphenyl)octyl phosphite.

In the present invention, phenol- and phosphite-based antioxidants are each preferably used in terms of, for example, the effects, the heat stability, and the economic efficiency of the antioxidants, and both the antioxidants are more preferably used in combination. The antioxidant is typically added in the base material in a content of about 0.1 to 1% by mass, preferably 0.2 to 0.5% by mass.

A resin film as the above-mentioned base material is formed by using the above-mentioned raw materials but may be oriented or unoriented. In addition, the resin film may be monolayered or multilayered.

This base material can be produced by a conventionally known method. For example, the unoriented film which is not substantially amorphous and not oriented can be manufactured by melting the raw materials by an extruder, extruding the melted raw materials by a ring die and a T-die, and quenching the extruded raw materials. Moreover, a monolayered film formed of one kind of resin, a multilayered film formed of one kind of resin, a multilayered film formed of many kinds of resins, and the like can be produced by using a multilayer die.

The unoriented film is oriented in the flow (longitudinal axis) direction of the film or the vertical (lateral axis) direction to the flow direction of the film by known methods such as uniaxial orientation, tenter type sequential biaxial extension, tenter type simultaneous biaxial orientation, and tubular simultaneous biaxial orientation to produce a film oriented in the uniaxis or biaxial direction. The oriented rate can be optionally set. The thermal shrinkage rate at 150 °C is preferably 0.01 to 5%, more preferably 0.01 to 2%. Particularly, from the viewpoint of the film properties, a coextruded biaxially oriented film in which a biaxially-oriented poly ethylene terephthalate film, a biaxially-oriented polyethylene naphthalate film, a polyethylene terephthalate, and/or a polyethylene naphthalate is coextruded with another resin is preferable.

The thickness of the base material of the above-mentioned moisture-resistant film is generally 5 to 300 $\mu$m. From the viewpoint of the curl suppression, the withstand voltage, the cushioning properties, the productivity, and the handleability of the solar cell protective material, the thickness of the base material of the moisture-resistant film is preferably 25 to 250 $\mu$m, more preferably 38 to 200 $\mu$m, further more preferably 50 to 180 $\mu$m. The base material forming the above-mentioned moisture-resistant film, which has a thickness of 25 $\mu$m or more, produces an excellent effect in suppressing curl generation in the solar cell protective material and imparts excellent withstand voltage, shock resistance, and cushioning properties. The above-mentioned base material having a thickness of more than 300 $\mu$m is unpreferable in the viewpoint of the productivity and the handleability.

Moreover, the thickness of the base material of the above-mentioned moisture-resistant film is preferably equal to or more than that of the above-mentioned fluorine-based resin film from the viewpoint of suppressing curl generation. Specifically, the ratio $T_{A'}/T_{B'}$ of the thickness $T_{A'}$ of the fluorine-based resin film to the thickness $T_{B'}$ of the base material of the moisture-resistant film is preferably 1.0 or less. From the viewpoint of suppressing curl generation, $T_{A'}/T_{B'}$ is more preferably 0.07 to 0.8, further more preferably 0.2 to 0.7.

On the above-mentioned base material, an anchor coat layer is preferably formed to improve the adhesion with the inorganic layer. For the anchor coat layer, a solvent or an aqueous polyester resin; alcoholic hydroxyl group-containing resins such as an isocyanate resin, an urethane resin, an acrylic resin, a modified vinyl resin, and a vinyl alcohol resin; and a vinyl butyral resin, a nitrocellulose resin, an oxazoline group-containing resin, a carbodiimide group-containing resin, a melamine group-containing resin, an epoxy group-containing resin, a modified styrene resin, a modified silicone resin, and the like can be used alone or in combination of two or more. In the anchor coat layer, alkyl titanate, a silane-based coupling agent, a titanium-based coupling agent, a UV absorber, a weather-resistant stabilizer, a lubricant, a blocking inhibitor, or an antioxidant, or the like can be optionally added. As the ultraviolet absorber, the weather-resistant stabilizer, and the antioxidant, the same types as those used for the above-mentioned base material or the polymer types in which a weather-resistant stabilizer and/or an ultraviolet absorber are copolymerized with the above-mentioned resin can be used.

From the viewpoint of improving the adhesion with the inorganic layer, the thickness of the anchor coat layer is preferably 10 to 200 nm, more preferably 10 to 100 nm. Known coating methods are appropriately adopted as the method of forming the anchor coat layer. For example, any method such as a coating method employing a reverse roll coater, a gravure coater, a rod coater, an air doctor coater, or a spray can be used. The base material may be immersed in a liquid resin. After the coating, the solvent can be evaporated by employing a known drying method such as hot-air drying at a temperature of about 80 to 200°C, heat drying such as heat roll drying, or infrared drying. In addition, a crosslinking treatment by electron beam irradiation can be performed for improving water resistance and durability. The anchor coat layer may be formed in the middle of the production line of the base material (in-line) or after the base material is produced (off-line).

Inorganic layer

An inorganic substance forming the inorganic layer is exemplified by silicon, aluminum, magnesium, zinc, tin, nickel, or titanium; or an oxide, carbide, or nitride thereof, or a mixture thereof. Among these, silicon oxide, silicon nitride, silicon oxynitride, aluminum oxide, and diamond-like carbon are preferable because of their transparency. In particular, silicon oxide, silicon nitride, silicon oxynitride, and aluminum oxide are preferable because they can stably maintain high gas barrier properties.

Any one of the methods such as a vapor deposition method and a coating method can be employed as a method of forming the inorganic layer. Among these, the vapor deposition method is preferable because a uniform thin layer having high gas barrier properties is obtained. The vapor deposition method includes physical vapor deposition (PVD) and chemical vapor deposition (CVD). Examples of the physical vapor deposition method include vacuum deposition, ion plating, and sputtering. Examples of the chemical vapor deposition method include plasma CVD involving utilizing plasma and a catalytic chemical vapor deposition method (Cat-CVD) involving subjecting a material gas to catalytic pyrolysis with a heating catalyst body.

The inorganic layer may be monolayered or multilayered. Each layer of the multilayer inorganic layer may be formed by using the same deposition method or a different deposition method. In any of these cases, the deposition is preferably sequentially conducted under reduced pressure from the viewpoint of efficiently improving the moisture resistance and the productivity.

Particularly, the multilayer structure preferably contains an inorganic layer formed by vacuum deposition, an inorganic layer formed by chemical vapor deposition, and an inorganic layer formed by vacuum deposition in the stated order. Each layer of the multilayer inorganic layer may be formed of the same inorganic substance or a different inorganic substance.

The thickness of the above-mentioned inorganic layer is preferably 10 to 1000 nm, more preferably 20 to 800 nm, further more preferably 20 to 600 nm from the viewpoint of exhibiting stable moisture resistance.

Pressure sensitive adhesive layer

In producing the solar cell protective material, for example, a pressure sensitive adhesive diluted by using a solvent is applied to a resin film or the like in a predetermined thickness, the solvent is typically evaporated by drying at a temperature falling within the range of 70 to 140 °C to form a pressure sensitive adhesive layer on the resin film or the like when component members forming the solar cell protective material, such as resin films, are laminated. Then, another resin film or the like is attached to the pressure sensitive adhesive layer. Finally, the solar cell protective material is produced through curing at a predetermined temperature. The curing is conducted a temperature falling within the range of 30 to 80 °C for from one day to one week.

In such a laminating process, the heat and the binding tension act on resin films and the like to accumulate residual strain in the solar cell protective material. However, the accumulated residual strain acts as the stress on each interlayer interface when the solar cell protective material is used and stored under high-temperature and high-humidity environment. Particularly, residual strain accumulated in the resin films is a factor in shrinking the resin films under high-temperature and high-humidity environment, stressing the inorganic layer, developing a defect in the inorganic layer, and causing the moisture resistance performance to degrade.

Thus, the fluorine-based resin film layer is preferably laminated to the moisture-resistant film through a pressure sensitive adhesive layer having a certain level of softness and thickness and adhering by van der Waals' force from the viewpoint of less transmitting the stress due to the shrinkage of the resin films being caused by the residual strain to the inorganic layer under high-temperature and high-humidity environment, of protecting the inorganic layer, and of preventing the moisture resistance from degrading. Therefore, the pressure sensitive adhesive layer preferably has a tensile storage elastic modulus of $5.0 \times 10^4$ to $5.0 \times 10^5$ Pa at a temperature of 100 °C, a frequency of 10 Hz, and a strain of 0.1%. Specifically, the tensile storage elastic modulus at 100 °C of $5.0 \times 10^4$ Pa or more can prevent the pressure sensitive adhesive layer from flowing and uniformly maintain the layer thicknesses when component members forming the solar cell protective material, such as resin films, are laminated. The tensile storage elastic modulus at 100 °C of $5.0 \times 10^5$ Pa or less can prevent damage from an inorganic layer by allowing the pressure sensitive adhesive layer to absorb the stress generated due to the shrinkage of films opposing each other through the pressure sensitive adhesive layer. The tensile storage elastic modulus at a temperature of 100 °C, a frequency of 10 Hz, and a strain of 0.1% of the pressure sensitive adhesive layer is preferably $7.0 \times 10^4$ to $5.0 \times 10^5$ Pa, more preferably $1.0 \times 10^5$ to $5.0 \times 10^5$ Pa.

From the viewpoint of maintaining the adhesive strength at normal temperature (20 °C), the tensile storage elastic modulus at a temperature of 20 °C, a frequency of 10 Hz, and a strain of 0.1% of the pressure sensitive adhesive layer is $1.0 \times 10^6$ Pa or more.

In addition, the degradation of the moisture resistance of the solar cell protective material may be caused by that of the pressure sensitive adhesive. To prevent this, selecting a pressure sensitive adhesive which is hardly hydrolyzed is effective.

From the above-mentioned viewpoints, in the present invention, the pressure sensitive adhesive used for the above-mentioned pressure sensitive adhesive layer preferably contains an acrylic pressure sensitive adhesive and more preferably contains an acrylic pressure sensitive adhesive as a main component. The purport of the term "main component" herein is that any other component may be incorporated to such an extent that the effects of the present invention are not impaired. The term "main component," which does not impose any limitation on a specific content, generally refers to a component that accounts for 50 parts by mass or more, preferably 65 parts by mass or more, further more preferably 80 parts by mass or more and 100 parts by mass or less based on 100 parts by mass of the entire constituents of the pressure sensitive adhesive layer.

The above-mentioned acrylic pressure sensitive adhesive is preferably formed of a polymer or a copolymer mainly containing a main monomer component having a low glass transition point (Tg) and imparting pressure sensitive adhesiveness, a comonomer component having a high Tg and imparting adhesiveness and cohesion force, and a functional group-containing monomer component for improving the crosslinking and the adhesiveness. The polymer or the copolymer hereinafter referred to as "acrylic (co)polymer."

Examples of the main monomer component of the above-mentioned acrylic (co)polymer include acrylic esters such as ethyl acrylate, butyl acrylate, amyl acrylate, 2-ethylhexyl acrylate, and octyl acrylate. These may be used alone or in combination of two or more.

Examples of the comonomer component of the above-mentioned acrylic (co)polymer include methyl acrylate, methyl methacrylate, ethyl methacrylate, butyl methacrylate, methacrylate 2-ethylhexyl, cyclohexyl methacrylate, benzyl methacrylate, vinyl acetate, styrene, and acrylonitrile. These may be used alone or in combination of two or more.

Examples of the functional group-containing monomer component of the above-mentioned acrylic (co)polymer include carboxyl group containing monomers such as acrylic acid, methacrylic acid, maleic acid, and itaconic acid, hydroxyl group-containing monomers such as 2-hydroxyethyl (meth)acrylate, 2-hydroxypropyl (meth)acrylate, N-methylolacrylamide, acrylamide, methacrylamide, and glycidylmethacrylate. These may be used alone or in combination of two or more.

Examples of the initiator used for polymerizing the monomer component of the above-mentioned acrylic (co)polymer include azobisisobutylnitrile, benzoyl peroxide, di-t-butyl peroxide, and cumene hydroperoxide. The copolymerized form of the acrylic (co)polymer as the main component of the above-mentioned acrylic pressure sensitive adhesive is not limited in particular, which may be a random, block, or graft copolymer.

When the above-mentioned acrylic pressure sensitive adhesive is the above-mentioned acrylic (co)polymer, the mass-average molecular weight of the above-mentioned acrylic pressure sensitive adhesive is preferably 300, 000 to 1,500,000, more preferably 400,000 to 1,000,000. The mass-average molecular weight falling within the above-mentioned range can secure the adhesion and the adhesive durability to an adherend so as to suppress floating or peeling.

In the above-mentioned acrylic (co)polymer, the content of a functional group-containing monomer component unit preferably falls within the range of 1 to 25 % by mass. The content falling within the above-mentioned range secures the adhesion and the degree of cross-linking to an adherend so as to adjust the tensile storage elastic modulus of the pressure sensitive adhesive layer to $5.0 \times 10^4$ to $5.0 \times 10^5$ Pa at a temperature of 100 °C, a frequency of 10 Hz, and a strain of 0.1%.

When the pressure sensitive adhesive layer and the inorganic layer form a strong chemical bond, the inorganic layer is subjected to large stress due to the change of the viscoelasticity of the pressure sensitive adhesive layer or the decomposition or the shrinkage of the pressure sensitive adhesive layer coating. The factor in forming a chemical bond between the inorganic layer and the pressure sensitive adhesive layer may be the reaction of the defective part of the inorganic layer such as a $SiO_x$ layer with a hydroxyl group or the like in the pressure sensitive adhesive layer. To suppress this, the number of reactive functional groups in the pressure sensitive adhesive only has to be decreased. Thus, the number of unreacted functional groups after the pressure sensitive adhesive layer is applied and cured is preferably decreased.

The pressure sensitive adhesive layer in the present invention preferably contains an ultraviolet absorber. As the ultraviolet absorber, the same types as those used for the above-mentioned base material can be used.

In the present invention, the pressure sensitive adhesive layer may be directly formed on the fluorine-based resin film or the moisture-resistant film. Alternatively, the pressure sensitive adhesive layer may be formed by applying the above-mentioned pressure sensitive adhesive to the peel-off face of a release sheet and then attaching this pressure sensitive adhesive layer to the moisture-resistant film.

The pressure sensitive adhesive to be applied (hereinafter referred to as "coating liquid") is based on an organic solvent, an emulsion, or a solventless pressure sensitive adhesive. The organic solvent-based pressure sensitive adhesive is preferable for the use of a solar cell material and the like requiring water resistance.

Examples of the organic solvent used for the organic solvent-based coating liquid include toluene, xylene, methanol, ethanol, isobutanol, n-butanol, acetone, methyl ethyl ketone, ethyl acetate, and tetrahydrofuran. These may be used alone or in combination of two or more.

The coating liquid is preferably prepared by using these organic solvents so that the solid content concentration falls within the range of 10 to 50 % by mass for the benefit and convenience of the application.

For example, the coating liquid can be applied by conventionally known coat methods such as a bar coat method, a roll coat method, a knife coat method, a roll-knife coat method, a die coat method, a gravure coating method, an air doctor coat method, and a doctor blade coat method.

After the application, the coating liquid is dried at 70 to 110 °C for about 1 to 5 minutes to form a pressure sensitive adhesive layer.

The thickness of the pressure sensitive adhesive layer is preferably 13 $\mu$m or more, more preferably 15 $\mu$m or more, further more preferably 18 $\mu$m or more, most preferably 20 $\mu$m or more from the viewpoint of obtaining sufficient adhesivity. From the viewpoint of obtaining the thickness capable of application, the thickness of the pressure sensitive adhesive layer is preferably 100 $\mu$m or less, more preferably 50 $\mu$m or less.

The solar cell protective material of the present invention preferably at least has the above-mentioned fluorine-based resin film, the above-mentioned pressure sensitive adhesive layer, and the above-mentioned moisture-resistant film in the stated order. When used for the front sheet, the solar cell protective material preferably has a fluorine-based resin film on the exposed side. Moreover, the inorganic layer side of the moisture-resistant film is preferably laminated to the fluorine-based resin film because the damage to the inorganic layer can be decreased when the solar cell protective material is stored and used when the fluorine-based resin film and the moisture-resistant film are laminated through the adhesive layer.

In the solar cell protective material of the present invention, other layers may be laminated for the purpose of further improving various physical properties (such as flexibility, heat resistance, transparency, and adhesiveness), molding processability, or economic efficiency within a range not departing from the spirit of the present invention.

Any layers that can be used for a solar cell protective material can typically be used as other layers that can be laminated in the solar cell protective material of the present invention. For example, layers of an encapsulating material, a collecting material, a conductive material, a heat-transfer material, a moisture adsorption material, and the like can be laminated.

Various additives can optionally be added to these layers. Examples of the additive include an antistat, an ultraviolet absorber, a plasticizer, a lubricant, a filler, a colorant a weather-resistant stabilizer, an anti-blocking agent, and an antioxidant but are not limited thereto. As the ultraviolet absorber, the weather-resistant stabilizer, and the antioxidant, the same types as those used for the above-mentioned base material can be used.

The thickness of the solar cell protective material of the present invention is not limited in particular but preferably 60 to 600 $\mu$m, more preferably 75 to 350 $\mu$m, further more preferably 90 to 300 $\mu$m from the viewpoint of suppressing curl generation and of the withstand voltage.

Moisture resistance of solar cell protective material

The solar cell protective material of the present invention can have an initial moisture resistance expressed by a moisture vapor permeability of preferably 0.1 g/m$^2$/day or less, more preferably 0.05 g/m$^2$/day or less by using the moisture-resistant film having an inorganic layer in the base material and a moisture vapor permeability less than 0.1 g/m$^2$/day as described above. Thus, the solar cell protective material of the present invention has excellent initial moisture resistance.

The solar cell protective material also has excellent moisture resistance and substantially prevents delamination when stored under high-temperature and high-humidity environment.

Moreover, using the above-mentioned pressure sensitive adhesive can adjust the moisture resistance to typically 25 or less, preferably 15 or less, more preferably 10 or less, further more preferably 2 or less expressed by the decreasing degree of moisture resistance under sequential high-temperature and high-humidity environment by vacuum lamination and pressure cooker test in accordance with JIS C 60068-2-66 (specifically, by the moisture vapor permeability after the high-temperature and high-humidity environment/initial moisture vapor permeability).

The "initial moisture resistance" of the solar cell protective material in the present invention is referred to as the moisture resistance before the member receives history, such as heat treatment under high-temperature and high-humidity environment such as the condition of vacuum lamination. This initial moisture resistance is determined before the moisture resistance is deteriorated by heat or the like. Thus, the initial moisture resistance includes temporal change immediately after the production before the high-temperature and high-humidity treatment. For example, the initial moisture resistance means a moisture resistance determined without heat treatment under high-temperature and high-humidity environment around 100 °C or heat lamination conducted at 130 to 180 °C for 10 to 40 minutes. The same holds for "initial moisture vapor permeability."

The moisture resistance in the present invention can be evaluated in accordance with the conditions of JIS Z0222 "Method of permeability test for moisture proof packing case" and JIS Z0208 "Testing methods for determination of the water vapor transmission rate of moisture-proof packaging materials (dish method)."

In the solar cell protective material of the present invention, the base material of the above-mentioned moisture-resistant film has a thickness of 25 to 250 $\mu$m so as to suppress curl generation. Furthermore, the solar cell protective material has a thickness of 90 $\mu$m or more so as to exhibit excellent withstand voltage and excellent cushioning properties. The withstand voltage can be evaluated by measuring the partial electrical discharge, specifically, by the method described in Examples.

In the solar cell protective material of the present invention, the partial electrical discharge measured in accordance with IEC60664-1:2007 Clause 6.1.3.5 is preferably 400 V or more, more preferably 600 V or more, further more preferably 800 V or more.

Encapsulating material-integrated protective material

The encapsulating material-integrated protective material of the present invention is formed by further laminating an encapsulating material layer to the moisture-resistant film side of the above-mentioned solar cell protective material. The encapsulating material-integrated protective material in which an encapsulating material layer is previously laminated can reduce the workload to individually laminate the front sheet, the encapsulating material, the electric power generating device, the encapsulating material, and the back sheet in vacuum lamination and thus can make the production of the solar cell module more efficient, in the below-mentioned production process of the solar cell module.

In the encapsulating material-integrated protective material of the present invention, examples of the encapsulating material forming the encapsulating material layer include a silicone resin-based encapsulating material, an ethylene-vinyl acetate copolymer, and a random copolymer of ethylene and an $\alpha$-olefin. Examples of the $\alpha$-olefin include propylene, 1-butene, 1-pentene, 1-hexene, 1-heptene, 1-octene, 1-nonene, 1-decene, 3-methyl-butene-1, and 4-methyl-pentene-1.

In the encapsulating material-integrated protective material, the width $W_D$ of the encapsulating material layer is less than the width $W_A$ of the above-mentioned fluorine-based resin film and more than the maximum width $W_P$ of a protective material-forming layer other than the above-mentioned fluorine-based resin film. Accordingly, the end faces of the protective material-forming layer other than the fluorine-based resin film are encapsulated with an encapsulating material in vacuum lamination so as to prevent the moisture resistance of the protective material from decreasing and prevent the delamination of the protective material.

The thickness of the encapsulating material layer to be laminated is preferably 200 to 750 $\mu$m, more preferably 300 to 600 $\mu$m from the viewpoint of the protection of the solar cell device.

Known methods can be used as the method of laminating an encapsulating material layer to the solar cell protective material of the present invention. For example, an encapsulating material layer only has to be laminated to the moisture-resistant film side of the solar cell protective material, optionally through an adhesive layer. For the adhesive layer, the same ones as the above-mentioned pressure sensitive adhesives or known adhesives such as a solvent-based adhesive, a thermosetting adhesive, and a hotmelt adhesive can be used. This adhesive preferably contains a polyurethane adhesive and more preferably contains a polyurethane adhesive as a main component.

Roll-shaped article

The roll-shaped article of the present invention is formed by rolling up the above-mentioned solar cell protective material or the above-mentioned encapsulating material-integrated protective material of the present invention. The roll-shaped article can improve the subsequent processability, transportability, and productivity and easily protect the appearance. The length of the roll is preferably 50 m or more, more preferably 100 m or more.

Roll-shaped article with cover sheet

The roll-shaped article with a cover sheet of the present invention is formed by rolling up the above-mentioned solar cell protective material or the above-mentioned encapsulating material-integrated protective material of the present invention. The roll-shaped article with a cover sheet is formed by at least partially covering a part at which the fluorine-based resin film projects from the surface of the roll-shaped article with a cover sheet having a deflection length of 70 mm or less and a load bearing dent of 0.1 or less. The deflection length and the load bearing dent are determined under the following conditions.

Deflection length

(1) A sample with a width of 20 mm and a length of 120 mm is collected.
(2) The sample is placed on and protruded from a platform so that the protuberance from the platform has a length of 100 mm, and then a 5 kg weight is added on the part of the sample on the platform to fix the sample.
(3) How much the end of the part of the sample being protruded from the platform hangs down from the platform is measured, and this measured length x (unit: mm) is determined as the deflection length.

The deflection length is an index of the deflectivity of a cover sheet or the like.

The deflection length is preferably measured in numerically-stable condition, which is typically measured 5 minutes after the sample is fixed. The temperature condition of the measurement is suitably about 23 °C.

A plate, the bottom face of which has an area of 20 mm $\times$ 20 mm, is first placed on the part of the sample on the platform, and then a 5 kg weight is added on this plate. The height of the plate is about 5 to 15 mm. The material of the plate is not limited in particular, which includes glass and iron.

Load bearing dent

(1) A 100 mm square sample is collected.
(2) The sample is placed on a glass plate with a thickness of 20 mm, a 0.5 g steel ball with a diameter of 5 mm is added on the central part of the sample, and a 2 kg load is further added on the steel ball.
(3) The dent "d" in the sample (unit: $\mu$m) is measured, and the ratio "d/t" of the dent "d" to the thickness "t" (unit: $\mu$m) of the sample is determined as the load bearing dent.

The load bearing dent is an index of the hard to denting of a cover sheet or the like. As the dent "d" of the sample, the depth of the deepest part of the dent is measured.

The load bearing dent is preferably measured in numerically-stable condition, which is typically measured at 23 °C for 24 hours after a steel ball is added on the sample, and then after a load is further added on the steel ball.

The above-mentioned solar cell protective material or the above-mentioned encapsulating material-integrated protective material of the present invention has projecting parts where the fluorine-based resin film is projected more than other protective material-forming layers because this film has such larger width. Thus, a roll-shaped article formed by rolling up the above-mentioned solar cell protective material or the above-mentioned encapsulating material-integrated protective material of the present invention also has such projecting parts. A roll-shaped article having such projecting parts may bend and wrinkle when transported.

The roll-shaped article with a cover sheet of the present invention prevents projecting parts from bending and wrinkling when transported by at least partially covering a part at which the fluorine-based resin film projects from the sides of the roll-shaped article.

The cover sheet only has to at least partially cover a part at which the fluorine-based resin film projects from the surface of the roll-shaped article. The cover sheet covers preferably 50% or more, more preferably 100% of this part.

In the further more preferable aspect, the cover sheet covers the entire surface of the roll-shaped article. The ratio of the width $W_K$ of the cover sheet and the width $W_A$ of the fluorine-based resin film ($W_K/W_A$) is 1 or more, more preferably 1.05 or more, further more preferably 1.15 or more. From the viewpoint of handleability, $W_K/W_A$ is preferably 1.5 or less, more preferably 1.3 or less.

The projecting parts bend and wrinkle by a load mainly from the vertical direction(thickness direction) of the roll-shaped article. Thus, covering the surface of the roll-shaped article with a cover sheet can achieve an objective of the present invention. Furthermore, the sides of the roll-shaped article may be covered with a cover sheet in consideration of a load from the right and left direction (width direction) of the roll-shaped article.

The deflection length is preferably 60 mm or less, more preferably 50 mm or less, further more preferably 40 mm or less. The load bearing dent is preferably 0.05 or less, more preferably 0.03 or less.

From the viewpoint of the handleability when the surface of the roll-shaped article is covered with a cover sheet and of maintaining the fixation of the ends in the longitudinal direction of the cover sheet, it is preferable that the deflection length be 5 mm or more and that the load bearing dent be 0.01 or more, and it is more preferable that the deflection length is 10 mm or more and that the load bearing dent is 0.02 or more.

As the cover sheet, plastic sheets formed of a polyolefin such as a homopolymer or a copolymer of ethylene, and propylene, butene; an amorphous polyolefin such as a cyclic polyolefin (Cyclo-Olefin-Polymer: COP); polyesters such as a polyethylene terephthalate (PET) and a polyethylene naphthalate (PEN); polyamides such as nylon 6, nylon 66, nylon 12, and copolymerized nylon; a polyimide, triacetyl cellulose (TAC), cellulose diacetate, cellulose acetate butyrate, polyethersulfone, polysulfone, polymethylpentene, polyvinyl chloride, polyvinyl acetal, polyether ketone, polymethyl methacrylate, polycarbonate, and polyurethane can be suitably used.

The thickness of the cover sheet is preferably 50 $\mu$m to 2 mm, more preferably 100 $\mu$m to 1 mm.

The cover sheet can cause blocking with the roll-shaped article. Particularly, the cover sheet located on the lower side of the roll-shaped article easily causes blocking between the roll-shaped article and the cover sheet by the weight of the roll-shaped article. Thus, the cover sheet preferably has a predetermined surface roughness. Specifically, the cover sheet has an arithmetic mean roughness Ra defined by JIS B 0601 of 50 nm or more.

The cover sheet has a predetermined strength and cushioning properties. Therefore, the foamed plastic films based on the plastic sheets given above are suitable.

The foamed plastic film is suitable in viewpoint of distinguishability from the opaque formed plastic film when the transparency of the laminate is high, in viewpoint of the excellent blocking resistance, and in viewpoint of the excellent handleability because of the lightweight.

In the present invention, the roll-shaped article only has to have a structure in which the cover sheet covers the surface of the roll-shaped article. However, the cover sheet is partially attached to the roll-shaped article by using a tape or an adhesive so as to remain the structure of the roll-shaped article. When the cover sheet covers the entire surface of the roll-shaped article, both the ends in the longitudinal direction of the cover sheet are preferably fixed with a tape or an adhesive.

In the present invention, the cover sheet and the fluorine-based resin film preferably meet the following conditions (a') and/or (b').

(a') deflection length of cover sheet / deflection length of fluorine-based resin film $\leq$ 2
(b') load bearing dent of cover sheet / load bearing dent of fluorine-based resin film $\leq$ 2

Meeting the above-mentioned condition (a') or (b') can more prevent projecting parts from bending and wrinkling. Meeting the above-mentioned conditions (a') and (b') can further more prevent projecting parts from bending and wrinkling.

(a') The deflection length of cover sheet / deflection length of fluorine-based resin film is preferably 1 or less, more preferably 0.1 to 0.6. (b') The load bearing dent of cover sheet / load bearing dent of fluorine-based resin film is preferably 1 or less, more preferably 0.5 or less, further more preferably 0.01 to 0.2.

Method of producing a solar cell protective material

The method of producing a solar cell protective material of the present invention sequentially carries out the following steps (1) to (3).

(1) A laminate X having a pressure sensitive adhesive layer is formed on a moisture-resistant film.
(2) Both the ends in the width direction of the laminate X are slit to form a laminate X'.
(3) A fluorine-based resin film having a width $W_A$ being more than the width $W_{X'}$ of the laminate X' is attached to the pressure sensitive adhesive layer so that both the ends of the fluorine-based resin film project from the respectively corresponding ends of the pressure sensitive adhesive layer.

Step (1)

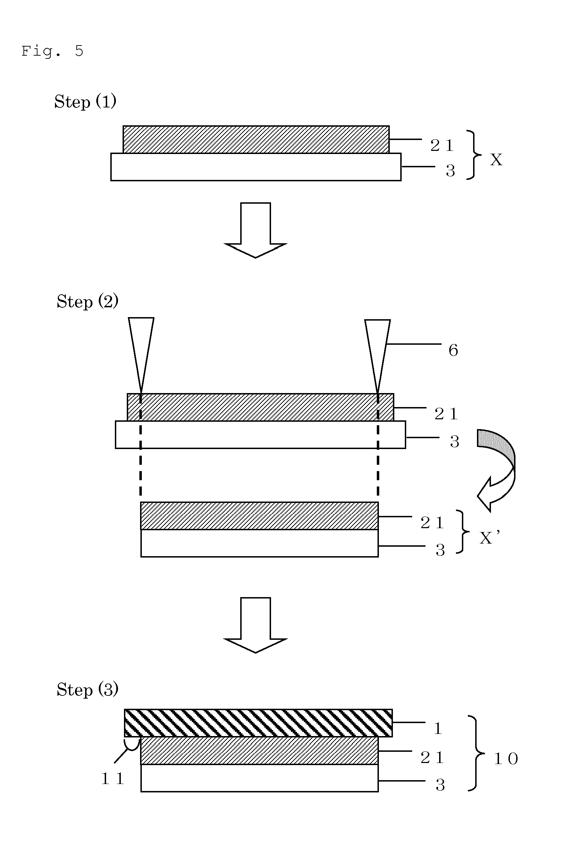

In the step (1), a laminate X having a pressure sensitive adhesive layer on a moisture-resistant film is formed.
The laminate X only has to have a pressure sensitive adhesive layer (21) on the moisture-resistant film (3) as shown in FIG.5. Although not shown in this figure, the laminate X may have another pressure sensitive adhesive layer, a functional layer, or the like on the other side of the moisture-resistant film (3).
To improve the slit workability in the step (2) and the handleability, a release sheet not shown in the figure is preferably disposed on the pressure sensitive adhesive layer.
The laminate X can be produced by applying a pressure sensitive adhesive layer composition to the moisture-resistant film and drying this pressure sensitive adhesive layer composition so as to form a pressure sensitive adhesive layer. The pressure sensitive adhesive layer can also be formed by transferring a pressure sensitive adhesive layer formed on another base material to the moisture-resistant film.
Having a release sheet, the laminate X can be produced by attaching a release sheet after the pressure sensitive adhesive layer is formed on the moisture-resistant film. However, a pressure sensitive adhesive layer composition is applied to a release sheet and dried to form a pressure sensitive adhesive layer, and then a moisture-resistant film preferably is attached to the pressure sensitive adhesive layer to form a laminate X.
According to the latter method, when the moisture-resistant film is formed of a material with poor heat resistance, a material with excellent heat resistance as the release sheet is suitably used so as to easily produce a laminate X having a pressure sensitive adhesive layer on a moisture-resistant film.
When a pressure sensitive adhesive layer composition is applied and dried on the moisture-resistant film or the release sheet to form a pressure sensitive adhesive layer, the conveyance rate of the moisture-resistant film or the release sheet is preferably 5 to 15 m/minute. The conveyance rate of 5 m/minute or more can increase the production efficiency. The conveyance rate of 15 m/minute or less can prevent air bubbles caused by the remaining solvent due to insufficient drying.

Step (2)

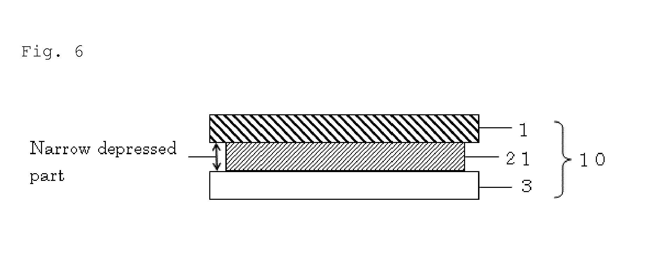

In the step (2), both the ends in the width direction of the laminate X is slit to form a laminate X'.
As shown in FIG.5, the width of the pressure sensitive adhesive (21) is less than those of the moisture-resistant film (3) and the release sheet when the step (1) has been completed. This causes difference in level on the sides of the laminate X. If a pressure sensitive adhesive layer composition is applied to equalize the widths of the pressure sensitive adhesive layer and the base material, the pressure sensitive adhesive layer composition wraps the back side of the base material, causing manufacturing failure. Thus, the difference caused in level on the sides of the laminate X is unavoidable due to manufacturing reasons.
If the fluorine-based resin film (1) is attached while the sides of the laminate have difference in level, narrow depressed parts are formed on the both sides of the laminate having projecting parts as shown in FIG. 6. In this case, when the laminate is vacuum-laminated by using an encapsulating material, air easily remains in these narrow depressed parts, easily causing air bubbles.
On the other hand, slitting in the step (2) like the present invention eliminates difference in level on the sides of the laminate X'. Even when the fluorine-based resin film is attached, narrow depressed parts cannot be formed on the sides of the laminate having projecting parts. Thus, air bubbles cannot be caused when vacuum lamination is conducted by using an encapsulating material.
At the position of the slit, all the materials forming the laminate X (the moisture-resistant film, the pressure sensitive adhesive layer, and the release sheet) can be preferably slit.

The slitting method is not limited in particular and can be conducted by using a known slitter.

When the laminate X has a release sheet, the release sheet is preferably peeled off after the step (2) and before the fluorine-based resin film is attached.

Step (3)

In the step (3), a fluorine-based resin film having a width $W_A$ being more than the width $W_{X'}$ of the laminate X' is attached to the pressure sensitive adhesive layer so that both the ends of the fluorine-based resin film project from the respectively corresponding ends of the pressure sensitive adhesive layer.

The laminate obtained in the step (3) has projecting parts 11, in which the fluorine-based resin film (1) is projected in the width direction from both the ends of the pressure sensitive adhesive layer (21) and the moisture-resistant film (3), as shown in FIG.5.

The laminate X' can be attached to the fluorine-based resin film by using a known laminator or the like. When this attachment, the widths of the laminate X' and the fluorine-based resin film are preferably adjusted by using an EPC (edge position control) device in order to increase the width of the fluorine-based resin film evenly in right and left directions to the width of the laminate X'.

In the step (3), the conveyance rate of the laminate X' and the fluorine-based resin film is preferably 20 to 30 m/minute. The conveyance rate of 20 m/minute or more can increase the production efficiency. The conveyance rate of 30 m/minute or less can easily adjust the width of the laminate X' and the fluorine-based resin film with an EPC device.

Method of producing solar cell module and solar cell

As a surface protective material for the solar cell, the solar cell protective material of the present invention can be used alone or by being attached to a glass plate or the like.

The solar cell module can be produced by using the solar cell protective material of the present invention for the layer structure of the surface protective material such as the front sheet or the back sheet and by fixing the solar cell device.

As such a solar cell module, various types can be given as examples. For example, the solar cell module is preferably produced by using an encapsulating material, a solar cell device, and a back sheet when the solar cell protective material of the present invention is used as the front sheet. Specifically, example structures of the solar cell module include a structure composed of a front sheet (the solar cell protective material of the present invention)/an encapsulating material(encapsulating resin layer)/a solar cell device/an encapsulating material(encapsulating resin layer)/a back sheet; a structure in which an encapsulating material and a front sheet (the solar cell protective material of the present invention) are formed on a solar cell device formed on the inner periphery of the back sheet; and a structure in which an encapsulating material and a back sheet are formed on a solar cell device formed on the inner periphery of a front sheet (the solar cell protective material of the present invention), for example, an amorphous solar cell device formed on a transparent fluorine resin-based protective material by sputtering or the like.

Examples of the solar cell device include single-crystalline silicon-type devices, polycrystalline silicon-type devices, amorphous silicon-type devices, various III-V and II-VI group compound semiconductor-type devices such as gallium-arsenic, copper-indium-selenium, copper-indium-gallium-selenium, and cadmium-tellurium, dye sensitization-type devices, and organic thin-film devices.

When a solar cell module is formed by using the solar cell protective material in the present invention, the moisture-resistant film is appropriately selected from a low moisture-resistant film with a moisture resistance expressed by a moisture vapor permeability of about less than 0.1 $g/m^2$/day to a high moisture-resistant film with a moisture resistance expressed by a moisture vapor permeability of about less than 0.01 $g/m^2$/day according to the type of the above-mentioned electric power generating device. Then, a pressure sensitive adhesive having a suitable tensile storage elastic modulus and a suitable thickness is used to form the layer structure.

Other members forming the solar cell module produced by using the solar cell protective material of the present invention is not limited in particular. The solar cell protective material of the present invention may be used for both the front sheet and the back sheet. Alternatively, a monolayered or a multilayered sheet such as a sheet formed of an inorganic material such as metal or glass and various thermoplastic resin films may be used for the front sheet or the back sheet. Examples of this metal include tin, aluminum, and stainless steel. Examples of this thermoplastic resin film include a monolayered and a multilayered sheet of a polyester, a fluorine-containing resin, a polyolefin, or the like. The surface of the front sheet and/or the back sheet can be subjected to known surface treatments such as priming treatment and corona treatment in order to improve the adhesiveness with the encapsulating material and other members.

The solar cell module produced by using the solar cell protective material of the present invention will be explained as one example of the above-mentioned structure composed of a front sheet (the solar cell protective material of the present invention)/an encapsulating material/a solar cell device/an encapsulating material/a back sheet. The solar cell module is formed by laminating the solar cell protective material of the present invention, an encapsulating material, a solar cell device, an encapsulating material, and a back sheet in the stated order from the sunlight-receiving side; and attaching a junction box (terminal box connecting a wiring for transmitting electricity generated from the solar cell device to outside) to the lower surface of the back sheet. The solar cell devices are coupled with each other by a wiring for conducting a generated current to outside. The wiring is taken to outside through a through-hole provided for the back sheet so as to be connected to the junction box.

As the method of producing a solar cell module, known production methods can be applied without any particular limitation. The method generally includes the steps of laminating the solar cell protective material of the present invention, an encapsulating resin layer, a solar cell device, an encapsulating resin layer, and a back sheet in the stated order, suctioning the laminated layer under vacuum, and crimping this laminate under heat. For example, the vacuum suction and heat-crimping are conducted with a vacuum laminator by heating at preferably 130 to 180 °C, more preferably 130 to 150 °C, deaerating for 2 to 15 minutes, pressing under 0.05 to 0.1 MPa for preferably 8 to 45 minutes, more preferably 10 to 40 minutes.

Batch manufacturing facilities and roll-to-roll manufacturing facilities can also be applied.

The solar cell module produced by using the solar cell protective material of the present invention can be variously used regardless of indoor or outdoor, for example, a small solar cell typically used for a mobile device, a large solar cell installed on a roof or a rooftop despite the type and the module form of a solar cell to be applied. Particularly, the solar cell module produced by using the solar cell protective material of the present invention is suitably used as a solar cell protective material for a solar cell module formed of a compound-type power-generating device, a flexible amorphous silicon solar cell module, and the like among electrical devices. Various physical properties were measured and evaluated as follows.

Examples

The present invention will be more specifically explained with reference to Examples but not limited to Examples and Comparative Examples.

Measurement of physical properties

(1) Tensile storage elastic modulus of pressure sensitive adhesive layer

The pressure sensitive adhesive was applied to the silicone release PET film so that the density is 25 g/m$^2$, cured at 40 °C for 4 days, and further maintained at 150 °C for 30 minutes to form the pressure sensitive adhesive layer. Then, only the pressure sensitive adhesive layer was removed. Subsequently, a predetermined number of pressure sensitive adhesive layers were overlayed so that the thickness is 200 $\mu$m. Then, a sample (length: 4 mm, width: 60 mm, thickness: 200 $\mu$m) was prepared. The stress to the strain applied to the obtained sample was measured at from -100 to 180 °C with a viscoelasticity-measurement device available under the trade name "Viscoelasticity Spectrometer DVA-200" available from IT Keisoku Co., Ltd. at an oscillation frequency of 10 Hz, a strain of 0.1%, a rate of temperature increase rate of 3°C/minute, and a chuck-to-chuck distance of 25 mm in the lateral direction. The tensile storage elastic modulus (MPa) at a temperature of 100 °C, a frequency of 10 Hz, and a strain of 0.1% was measured from the obtained data.

(2) Encapsulated state of end faces

A glass, an encapsulating material, and each of solar cell protective materials E-1 to E-6 were laminated in the stated order so that the fluorine-based resin film is disposed on the exposed side. Then, vacuum lamination was conducted under the condition of 150 °C × 15 minutes. Subsequently, the state of the end faces was observed and evaluated by the following criteria.

(AA) The encapsulating material reaches the width end faces of the fluorine-based resin film and is not drastically reduced in thickness.

(F) The encapsulating material is not wrapped around the width end faces of the fluorine-based resin film, or the encapsulating material that reaches the width end faces of the fluorine-based resin film has a small thickness and reduced in thickness at the end faces.

(3) Pressure cooker (PC) test

The solar cell protective materials (E-1 to E-6) were subjected to vacuum lamination by the above-mentioned method and then to pressure cooker test at a temperature of 105 °C and a humidity of 100% for 48 hours (PC48) by using a pressure cooker testing machine (trade name:LSK-500) available from TOMY SEIKO CO.,LTD. Then, the moisture vapor permeability was measured.

(4) Pressure cooker (PC) delamination test

The cured solar cell protective materials (E-1 to E-6) were subjected to vacuum lamination by the above-mentioned method and then to pressure cooker test at a temperature of 105 °C and a humidity of 100% by using a pressure cooker testing machine (trade name:LSK-500) available from TOMY SEIKO CO.,LTD. Then, the test time until delamination was visually confirmed in the end faces of the solar cell protective material was measured. When delamination was not able to be confirmed within 90 hours, the test time was determined as more than 90 hours (>90).

(5) Moisture vapor permeability

The moisture vapor permeability of the moisture-resistant film was measured by the following method as the moisture vapor permeability at the time when the prepared moisture-resistant film was stored at 40 °C for 1 week. For the solar cell protective materials (E-1 to E-6), the measured value after each of the cured solar cell protective materials was determined as the initial moisture vapor permeability. After this curing, a glass and each of the solar cell protective materials (a fluorine-based resin film was disposed on the exposed side) were laminated and subjected to heat treatment at 150 °C for 30 minutes. The measured value of each of the solar cell protective materials after pressure cooker test was conducted under the above-mentioned condition (3) was determined as the moisture vapor permeability after the pressure cooker test.

Specifically, the moisture vapor permeability was evaluated by the following method in accordance with the conditions of JIS Z0222 "Method of permeability test for moisture proof packing case" and JIS Z0208 "Testing methods for determination of the water vapor transmission rate of moisture-proof packaging materials (dish method)."

About 20 g of anhydrous chloride calcium was added between two sheets of solar cell protective material with a moisture permeation area of 10.0 cm $\times$ 10.0 cm as an absorbent, and then the sheets were sealed at the all sides to prepare a bag. The bag was set in a constant temperature and humidity device with a temperature of 40 °C and a relative humidity of 90% and subjected to mass measurement at intervals of 72 hours or more until the 200th day. The moisture vapor permeability g/m$^2$/day was calculated from the slope of the regression line for the relationship between the elapsed time after the 4th day and the weight of the bag. The decreasing degree of the moisture resistance was calculated by the following

```
expression: moisture vapor permeability after pressure cooker

test (PC48)/initial moisture vapor permeability.
```

Structural film

Fluorine-based resin film

As the fluorine-based resin film, the following size of a tetrafluoroethylene-ethylene copolymer (ETFE) film (trade name "Aflex 50 MW1250DCS" available from ASAHI GLASS CO., LTD. , thickness: 50 $\mu$m) was used.

A-1: The fluorine-based resin film was cut into a width of 200 mm.
A-2: The fluorine-based resin film was cut into a width of 230 mm
A-3: The fluorine-based resin film was cut into a width of 180 mm

Pressure sensitive adhesive 1

With a reactor equipped with a thermometer, a stirrer, a reflux cooling tube, and a nitrogen gas inlet tube, 0.3 parts by mass of azobisiso butyronitrile were added in a mixed solution of 90 parts by mass of butyl acrylate, 10 parts by mass of acrylic acid, 75 parts by mass of ethyl acetate, and 75 parts by mass of toluene, and the mixture was polymerized at 80 °C under a nitrogen gas atmosphere for 8 hours. After the reaction ends, the solid content was adjusted to 30 % by mass with toluene to obtain a resin with a mass-average molecular weight of 500,000. 1.0 part by mass of CORONATE L (trade name of Nippon Polyurethane Industry Co., Ltd, solid content: 75 parts by mass) was added in 100 parts by mass of the obtained resin as an isocyanate-based crosslinking agent to prepare a pressure sensitive adhesive 1. Table 1 shows the result of the tensile storage elastic modulus measured at 100 °C.

Pressure sensitive adhesive 2

With a reactor equipped with a thermometer, a stirrer, a reflux cooling tube, and a nitrogen gas inlet tube, 0.3 parts by mass of azobisiso butyronitrile were added in a mixed solution of 40 parts by mass of butyl acrylate, 10 parts by mass of isobutyl acrylate, 40 parts by mass of methyl acrylate, 10 parts by mass of acrylic acid, 75 parts by mass of ethyl acetate, and 75 parts by mass of toluene, and the mixture was polymerized at 80 °C under a nitrogen gas atmosphere for 8 hours. After the reaction ends, the solid content was adjusted to 30 % by mass with toluene to obtain a resin with a mass-average molecular weight of 500,000. 1.0 part by mass of CORONATE L (trade name of Nippon Polyurethane Industry Co., Ltd, solid content: 75 parts by mass) was added in 100 parts by mass of the obtained resin as an isocyanate-based crosslinking agent to prepare a pressure sensitive adhesive 2. Table 1 shows the result of the tensile storage elastic modulus measured at 100 °C.

Moisture-resistant film

The following coating liquid was applied to and dried on the corona treated side of a biaxially-oriented polyethylene naphthalate film with a thickness of 12 $\mu$m ("Q51C12" available from Teijin DuPont Films Japan Limited) used as the base material to form an anchor coat layer with a thickness of 0.1 $\mu$m.

Then, SiO was evaporated by heating under $1.33 \times 10^{-3}$ Pa ($1 \times 10^{-5}$ Torr) with a vacuum deposition device to obtain a moisture-resistant film having a $SiO_x$ (x=1.5) layer with a thickness of 50 nm on the anchor coat layer. The obtained moisture-resistant film was cut into a width of 180 mm. The moisture vapor permeability of this moisture-resistant film B-1 was 0.01 g/m$^2$/day.

Coating liquid

220 g of a polyvinyl alcohol resin "Gohsenol" available from Nippon Synthetic Chemical Industry Co., Ltd., (saponification value: 97.0 to 98.8 % by mole, polymerization degree: 2400) was added to 2810 g of ion exchange water and dissolved by heating. Then, 645 g of 35 % by mole of hydrochloric acid was added in the aqueous solution while being stirred at 20 °C. Subsequently, 3.6 g of butyraldehyde was added while being stirred at 10 °C. After 5 minutes, 143 g of acetaldehyde was added dropwise while being stirred to precipitate resin microparticles. After maintained at 60 °C for 2 hours, the liquid was cooled, neutralized with sodium hydrogen carbonate, washed with water, and dried to obtain polyvinyl acetoacetal resin powders (degree of acetalization: 75 % by mole).

The obtained resin powders were mixed with an isocyanate resin "Sumidur N-3200" available from Sumitomo Bayer Urethane Co., Ltd as a crosslinking agent so that the equivalence ratio of the isocyanate group to the hydroxyl group is 1:2.

Adhesive and adhesive coating liquid

"HD1013" available from ROCK PAINT used as a main agent containing a polyurethane polyol component was mixed with "H62" available from ROCK PAINT used as a curing agent containing a hexamethylene diisocyanate component so that the weight ratio is 10:1. The mixture was diluted with ethyl acetate so that the concentration of the solid content is 30%. Then, an adhesive coating liquid was prepared.

Encapsulating material

The encapsulating material under the trade name "EVASKY S11" available from Bridgestone Corporation (thickness: 500 $\mu$m, melting point: 69.6 °C) was used.

Glass

The solar cell cover glass TCB09331 (thickness: 3.2 mm) available from AGC Fabritech Co., LTD., was cut into to the same size as that of each of the fluorine-based resin films used in Examples and Comparative Examples.

Example 1

The pressure sensitive adhesive 1 was applied to a silicone release PET film with a thickness of 38 $\mu$m (NS-38+A available from Nakamoto Packs Co., Ltd., melting point: 262 °C, width: 180 mm) so that the thickness is 20 $\mu$m.

Then, the pressure sensitive adhesive 1 was dried to form a pressure sensitive adhesive layer. The $SiO_x$ side of the moisture-resistant film was attached to the formed pressure sensitive adhesive layer, the silicone release PET film was peeled off, and then the fluorine-based resin film A-1 was attached to the pressure sensitive adhesive layer. These layers were cured at 40 °C for 4 days to prepare a solar cell protective material E-1 with a thickness of 82 $\mu$m. The lengths of the fluorine-based resin film, the moisture-resistant film, and the pressure sensitive adhesive layer are approximately the same.

The glass, the encapsulating material, and the solar cell protective material E-1 were laminated in the stated order so that the fluorine-based resin film is disposed on the exposed side. Then, vacuum lamination was conducted on the condition of 150 °C $\times$ 15 minutes, and the encapsulated state of the end faces was evaluated. Subsequently, pressure cooker test and pressure cooker delamination test were conducted to measure the moisture vapor permeability and the test time until delamination. Table 1 shows the results.

Example 2

Except for using the fluorine-based resin film A-2, a solar cell protective material E-2 with a thickness of 82 $\mu$m was prepared in the same manner as Example 1. Then, the encapsulated state of the end faces, the moisture vapor permeability, and the test time until delamination were evaluated in the same manner as Example 1. Table 1 shows the results.

Example 3

The pressure sensitive adhesive 1 was applied to a silicone release PET film with a thickness of 38 $\mu$m (NS-38+A available from Nakamoto Packs Co., Ltd., melting point: 262 °C, width: 180 mm) so that the thickness is 20 $\mu$m. Then, the pressure sensitive adhesive 1 was dried to form a pressure sensitive adhesive layer. The $SiO_x$ side of the moisture-resistant film was attached to the formed pressure sensitive adhesive layer, the silicone release PET film was peeled off, and then the fluorine-based resin film A-1 was attached to the pressure sensitive adhesive layer.

Then, an adhesive coating liquid was applied to a poly ethylene terephthalate film with a thickness of 188 $\mu$m so that the thickness is 7 $\mu$m. The adhesive coating was dried to form an adhesive face. This adhesive face was attached to the moisture-resistant film side of the previously-prepared laminate. These layers were cured at 40 °C for 4 days to prepare a solar cell protective material E-3 with a thickness of 287 $\mu$m. Then, the encapsulated state of the end faces, the moisture vapor permeability, and the test time until delamination were evaluated in the same manner as Example 1. Table 1 shows the results.

Example 4

Except for changing the pressure sensitive adhesive 1 to the pressure sensitive adhesive 2, a solar cell protective material E-4 with a thickness of 82 $\mu$m was prepared in the same manner as Example 1. Then, the encapsulated state of the end faces, the moisture vapor permeability, and the test time until delamination were evaluated in the same manner as Example 1. Table 1 shows the results.

Comparative Example 1

Except for changing the fluorine-based resin film A-1 to the fluorine-based resin film A-3, a solar cell protective material E-5 with a thickness of 82 $\mu$m was prepared in the same manner as Example 1. Then, the encapsulated state of the end faces, the moisture vapor permeability, and the test time until delamination were evaluated in the same manner as Example 1. Table 1 shows the results.

Table 1

Table. 1

| | Protective material No. | Fluorine-based resin film | | Width of moisture-resistant (maximum width $W_P$ of protective material-forming layer) (mm) | $W_P/W_A$ | Pressure sensitive adhesive agent layer | | Encapsulated state of end faces | Moisture vapor permeability [g/m²/day] | | | PC test time until delamination |
|---|---|---|---|---|---|---|---|---|---|---|---|---|
| | | Type | Width $W_A$ (mm) | | | Pressure sensitive adhesive agent | Tensile storage elastic modulus [x10⁵ Pa 100 °C] | | Initial | 48 hours after PC | decreasing degree of moisture resistance | |
| Example 1 | E-1 | A-1 | 200 | 180 | 0.90 | B-1 | 3 | AA | 0.01 | 0.02 | 2 | >90 |
| Example 2 | E-2 | A-2 | 230 | 180 | 0.783 | B-1 | 3 | AA | 0.01 | 0.02 | 2 | >90 |
| Example 3 | E-3 | A-1 | 200 | 180 | 0.90 | B-1 | 3 | AA | 0.01 | 0.02 | 2 | >90 |
| Example 4 | E-4 | A-1 | 200 | 180 | 0.90 | B-2 | 8 | AA | 0.01 | 0.24 | 24 | >90 |
| Comparative Example 1 | E-5 | A-3 | 180 | 180 | 1.00 | B-1 | 3 | F | 0.01 | 0.02 | 2 | 60 |

As is apparent from Table 1, Examples 1 to 4 falling within the scope of the present invention had excellent moisture resistance and substantially prevented delamination. On the other hand, Comparative Example 1 in which the widths of the layers forming the solar cell protective material depart from the scope of the present invention degraded the performance of prevention of delamination.

Example 5

The pressure sensitive adhesive 1 was applied to the moisture-resistant film side of the solar cell protective material E-1 prepared in Example 1 so that the thickness is 5 $\mu$m and then dried to form an adhesive layer 1 formed of the pressure sensitive adhesive 1. An encapsulating material D-1 with a width of 190 mm was laminated to the formed pressure sensitive adhesive layer. These layers were cured at 40 °C for 4 days to prepare an encapsulating material-integrated protective material F-1 with a thickness of 700 $\mu$m.

In the obtained encapsulating material-integrated protective material F-1, the adhesiveness between the solar cell protective material E-1 and the encapsulating material layer was excellent. Moreover, for the encapsulating material-integrated protective material F-1, the PC test time until delamination and the encapsulated state of the end faces were evaluated. From the evaluation, the encapsulating material-integrated protective material F-1 had superior workability to Example 1 and was rated as high as Example 1.

Moisture-resistant films B-2 to B-4

Except for changing the base material of the moisture-resistant film B-1 to the biaxially-oriented polyethylene naphthalate film (T100 available from Mitsubishi Plastics, Inc.) with a thickness of 125 $\mu$m, a moisture-resistant film B-2 was prepared in the same manner as the moisture-resistant film B-1. The moisture vapor permeability of this moisture-resistant film B-2 was 0.01 g/m$^2$/day.

Except for changing the base material of the moisture-resistant film B-1 to the biaxially-oriented polyethylene naphthalate film (T100 available from Mitsubishi Plastics, Inc.) with a thickness of 100 $\mu$m, a moisture-resistant film B-3 was prepared in the same manner as the moisture-resistant film B-1. The moisture vapor permeability of this moisture-resistant film B-3 was 0.01 g/m$^2$/day.

Except for changing the base material of the moisture-resistant film B-1 to the biaxially-oriented polyethylene naphthalate film (T100 available from Mitsubishi Plastics, Inc.) with a thickness of 50 $\mu$m, a moisture-resistant film B-4 was prepared in the same manner as the moisture-resistant film B-1. The moisture vapor permeability of this moisture-resistant film B-4 was 0.01 g/m$^2$/day.

(6) Curl evaluation

The solar cell protective materials E6 to E8 were placed flat in an oven maintained at 150 °C and left for 5 minutes. Then, the heights of the four corners of each of the protective materials were measured with a micro caliper. The average of the measured values of the four corners was determined as the curl value. The marked line was determined as the face where the platform is in contact with the protective materials when the protective materials are placed on a horizontal platform so that the fluorine-based resin film faces up. The effect in suppressing curl generation was evaluated from the following criteria based on the measurement result of the curl value.

AA: The curl value is 0 to 40 mm.
A: The curl value is more than 40 mm and 80 mm or less.
F: The curl value is more than 80 mm.

(7) Partial electrical discharge

The partial electrical discharge of each of the solar cell protective materials E6 to E8 was measured in accordance with IEC 60664-1:2007 Clause 6.1.3.5. The measurement was conducted in a measurement room, in which the temperature and the relative humidity are controlled to 23$\pm$5 °C and 40$\pm$10%, respectively.

Example 6

Except for using the moisture-resistant film B-2, a solar cell protective material E-6 with a thickness of 195 $\mu$m was prepared in the same manner as Example 1.

Example 7

Except for using the moisture-resistant film B-3, a solar cell protective material E-7 with a thickness of 170 μm was prepared in the same manner as Example 1.

Example 8

Except for using the moisture-resistant film B-4, a solar cell protective material E-8 with a thickness of 120 μm was prepared in the same manner as Example 1.

Table 2

Table 2

| | Protective material No. | Curling | | Partial electrical discharge (V) |
| --- | --- | --- | --- | --- |
| | | Curl value (mm) | Result | |
| Example 6 | E-6 | 38 | AA | 960 |
| Example 7 | E-7 | 51 | A | 760 |
| Example 8 | E-8 | 76 | A | 540 |

As shown in Table 2, each solar cell protective material of Examples 6 to 8 had excellent effect in suppressing curl generation and excellent electric strength. For each solar cell protective material of Examples 6 to 8, the encapsulated state of the end faces, the moisture vapor permeability, and the test time until delamination were evaluated in the same manner as Example 1. From the evaluation, the laminates were rated as high as Example 1.

Cover sheets K-1 to K-4

The following cover sheets were prepared.

K-1: Foamed polyethylene sheet (poren sheet available from Poren chemical industry, thickness: 700 μm, width: 250 mm)
K-2: Polypropylene film (polypropylene sheet (product code: 07-175-02) available from KOKUGO Co., Ltd., thickness: 500 μm, width: 250 mm)
K-3: Transparent polyester film (Diafoil T100 available from Mitsubishi Plastics, Inc., thickness: 380 μm, width: 250 mm)
K-4: Polyethylene film (product code: 125-18-18-01 available from TGK company, thickness: 30 μm, width: 250 mm)

(8) Deflection length

As shown in FIG.3, each of the cover sheets and the fluorine-based resin film A-1 were cut into a strip with a width of 20 mm and a length of 120 mm to prepare a measurement sample S of the cover sheet and the fluorine-based resin film. Subsequently, the sample S was placed on and protruded from a platform 71 with a height of 100 mm or more so that the protuberance from the platform has a width of 20 mm and a length of 100 mm. An iron plate with a height of 10 mm, the bottom face of which has an area of 20 mm × 20 mm, was placed on the part of the sample on the platform. Then, a 5 kg weight 72 was added on the iron plate. How much the end of the part of the sample S being protruded from the platform 71 hangs down from the platform was measured, and this measured length × (unit: mm) was determined as the deflection length.

Five minutes after the sample was fixed, the measurement was conducted at 23 °C Table 3 shows the results.

(9) Load bearing dent

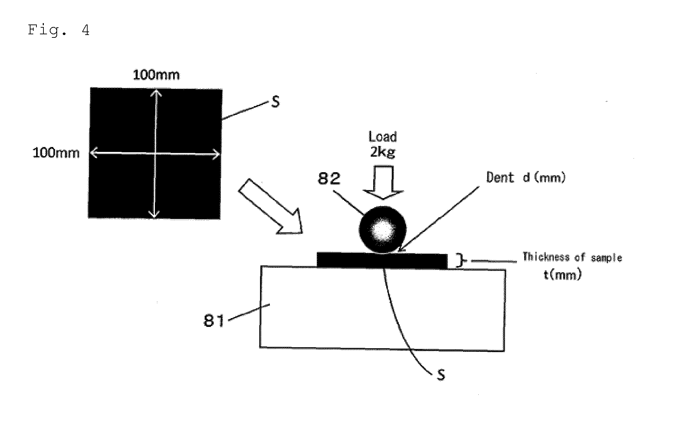

As shown in FIG.4, each of the cover sheets and the fluorine-based resin film A-1 were cut into a 100 mm square to prepare a measurement sample S of the cover sheet and the fluorine-based resin film. Then, the sample S was placed on a glass plate 81 with a thickness of 20 mm, a 0.5 g steel ball 82 with a diameter of 5 mm was added on the central part of the sample, and a 2 kg load was further added on the steel ball 82. After 24 hours, the depth of the deepest part of the dent "d" in the sample S (unit: μm) was measured at 23 °C. The ratio "d/t" of the dent "d" to the thickness "t" (unit: μm) of the sample was determined as the load bearing dent. Table 3 shows the results.

(10) Bending resistance of projecting parts

For each of the roll-shaped articles with a cover sheet obtained in Examples 9 to 11 and Reference Example 1, a 5 kg load was applied to the cover sheet on the part corresponding to the projecting parts for 24 hours. The fluorine-based resin film was visually observed and evaluated by the following criteria. Table 3 shows the results.

(AA): The parts protruding more than the moisture-resistant film of the fluorine-based resin film are not bent.
(F): The parts protruding more than the moisture-resistant film of the fluorine-based resin film are bent.

(11) Fixation of ends of cover sheet (handleability)

The roll-shaped articles with a cover sheet obtained in Examples 9 to 11 and Reference Example 1 were evaluated by the following criteria. Table 3 shows the results.

(AA) : The ends of the cover sheet can be fixed for 3 days or more.
(A): The ends of the cover sheet cannot be fixed for 3 days.

Example 9

The pressure sensitive adhesive 1 was applied to a silicone release PET film with a thickness of 38 $\mu$m (NS-38+A available from Nakamoto Packs Co., Ltd. , melting point: 262 °C, width: 180 mm) so that the thickness is 20 $\mu$m and then dried to form a pressure sensitive adhesive layer. The SiO$_x$ side of the moisture-resistant film was attached to the formed pressure sensitive adhesive layer, the silicone release PET film was peeled off, and then the fluorine-based resin film A-1 was attached to the pressure sensitive adhesive layer. Then, the laminate (solar cell protective material) having the structure of fluorine-based resin film A-1/pressure sensitive adhesive layer/moisture-resistant film B-1 was obtained.
The laminate was winded on a core with an outer diameter of 172.4 mm to obtain a 200 m roll-shaped article. Subsequently, the roll-shaped article was cured at 40 °C for 4 days. The entire surface of the cured roll-shaped article was covered with the cover sheet K-1. The ends of the roll-shaped article were fixed with a piece of tape (Pyolan Tape available from DIATEX Co., Ltd., cut into 50 mm in width $\times$ 100 mm in length) to obtain a roll-shaped article with a cover sheet of Example 9.

Example 10

Except for using the cover sheet K-2, the roll-shaped article with a cover sheet of Example 10 was obtained in the same way as Example 9.

Example 11

Except for using the cover sheet K-3, the roll-shaped article with a cover sheet of Example 11 was obtained in the same way as Example 9.

Reference Example 1

Except for using the cover sheet K-4, the roll-shaped article with a cover sheet of Reference Example 1 was obtained in the same way as Example 9.
Table 3

Table 3

| | Fluorine-based resin film | | Cover sheet | | | Cover sheet/Fluorine-based resin film | | Bending resistance | Handleability |
|---|---|---|---|---|---|---|---|---|---|
| | Deflection length (mm) | Load bearing dent | Type | Deflection length (mm) | Load bearing dent | Deflection length (mm) | Load bearing dent | | |
| Example 9 | 95 | 0.04 | K-1 | 10 | 0.03 | 0.11 | 0.75 | AA | AA |
| Example 10 | 95 | 0.04 | K-2 | 33 | 0.02 | 0.34 | 0.50 | AA | AA |
| Example 11 | 95 | 0.04 | K-3 | 38 | 0.01 | 0.40 | 0.25 | AA | A |
| Reference Example 1 | 95 | 0.04 | K-4 | 98 | 0.10 | 1.03 | 2.5 | F | AA |

As shown in Table 3, the roll-shaped articles with a cover sheet of Examples 9 to 11 had excellent bending resistance and excellent handleability. For the laminates (solar cell protective material) forming roll-shaped articles with a cover sheet of Examples 9 to 11, the encapsulated state of the end faces, the moisture vapor permeability, and the test time until delamination were evaluated in the same manner as Example 1. From the evaluation, the laminates were rated as high as Example 1.

(12) Air bubbles

The glass, the encapsulating material, and each of the solar cell protective materials (E-12, E-13, and E-6) of Examples 12 and 13 and Comparative Example 1 were laminated in the stated order so that the fluorine-based resin film is disposed on the exposed side. With a vacuum laminator (LM-30×30 available from MPC Incorporated), the vacuum suction was conducted by heating at 150 °C, deaerating for 5 minutes, pressing under 0.1 MPa for 10 minutes. Subsequently, the laminate was observed and evaluated by the following criteria.

(AA): No air bubbles are confirmed.
(F): One or more air bubbles are confirmed.

Example 12

The pressure sensitive adhesive 1 was applied to a silicone release PET film with a thickness of 38 $\mu$m (NS-38+A available from Nakamoto Packs Co., Ltd., melting point: 262 °C, width: 200 mm) so that the thickness is 20 $\mu$m and then dried to form a pressure sensitive adhesive layer to prepare a pressure sensitive adhesive sheet.
The pressure sensitive adhesive sheet was attached to the $SiO_x$ side of the moisture-resistant film B-1 to obtain a laminate X. Subsequently, both the ends in the width direction of the laminate X each were slit off 10 mm to form a laminate X' (width $W_{X'}$: 180 mm).
The release sheet of the laminate X' was peeled off, the fluorine-based resin film A-1 was attached to the laminate X', and the laminate was cured at 40 °C for 4 days. Then, the solar cell protective material E-12 of Example 12 having the structure of fluorine-based resin film A-1/pressure sensitive adhesive layer/moisture-resistant film B-1 was obtained.

Example 13

Except for using the fluorine-based resin film A-2, the solar cell protective material E-13 of example 13 was obtained in the same way as Example 12.
Table 4

Table 4

|  | $W_P/W_A$ | Slit | Air bubbles |
|---|---|---|---|
| Example 12 | 0.90 | Slit | AA |
| Example 13 | 0.78 | Slit | AA |
| Comparative Example 1 | 1.00 | Not slit | F |

As shown in Table 4, the solar cell protective materials of Examples 12 and 13 did not cause any bubbles. For each solar cell protective material of Examples 12 and 13, the encapsulated state of the end faces, the moisture vapor permeability, and the test time until delamination were evaluated in the same manner as Example 1. From the evaluation, the laminates were rated as high as Example 1. Reference Signs List
1:      fluorine-based resin film
21:     pressure sensitive adhesive layer
3:      moisture-resistant film

51, 52:    release sheet
6:      slitter
10:     solar cell protective material

11:         projecting part
20:         encapsulating material
30:         solar cell

**Claims**

1. A solar cell protective material comprising: a fluorine-based resin film; a pressure sensitive adhesive layer; and a moisture-resistant film having a base material and an inorganic layer on at least one side of the base material, the moisture-resistant film having a moisture vapor permeability of less than 0.1 g/m$^2$/day, wherein the fluorine-based resin film, the pressure sensitive adhesive layer, and the moisture-resistant film are laminated as a protective material-forming layer P, and the ratio ($W_P/W_A$) of the maximum width $W_P$ of the protective material-forming layer P other than the fluorine-based resin film to the width $W_A$ of the fluorine-based resin film is less than 1.

2. The solar cell protective material according to claim 1, wherein $W_P/W_A$ is 0.7 to 0.98.

3. The solar cell protective material according to claim 1 or 2, wherein the layer having the maximum width of the protective material-forming layer P other than the fluorine-based resin film is the moisture-resistant film.

4. The solar cell protective material according to any one of claims 1 to 3, wherein the pressure sensitive adhesive layer has a tensile storage elastic modulus of $5.0 \times 10^4$ to $5.0 \times 10^5$ Pa at a temperature of 100 °C, a frequency of 10 Hz, and a strain of 0.1% and also has a thickness of 13 $\mu$m or more.

5. The solar cell protective material according to any one of claims 1 to 4, wherein the thickness of the base material is 25 to 250 $\mu$m.

6. The solar cell protective material according to any one of claim 1 to 5, wherein the inorganic layer side of the moisture-resistant film is laminated to the fluorine-based resin film.

7. An encapsulating material-integrated protective material formed by further laminating an encapsulating material layer to the moisture-resistant film side of the solar cell protective material according to any one of claims 1 to 6.

8. The encapsulating material-integrated protective material according to claim 7, wherein the width $W_D$ of the encapsulating material layer is less than the width $W_A$ of the fluorine-based resin film and more than the maximum width $W_P$ of the protective material-forming layer P other than the fluorine-based resin film.

9. A roll-shaped article formed by rolling up the solar cell protective material according to any one of claims 1 to 6 or the encapsulating material-integrated protective material according to claim 7 or 8.

10. A roll-shaped article with a cover sheet formed by at least partially covering a part at which the fluorine-based resin film projects from the surface of the roll-shaped article according to claim 9 with a cover sheet having a deflection length of 70 mm or less and a load bearing dent of 0.1 or less, wherein
the deflection length is measured in a condition in which

(1) A sample with a width of 20 mm and a length of 120 mm is collected,
(2) the sample is placed on and protruded from a platform so that the protuberance from the platform has a length of 100 mm , and then a 5 kg weight is added on the part of the sample on the platform to fix the sample, and
(3) how much the end of the part of the sample being protruded from the platform hangs down from the platform is measured, and this measured length x (unit: mm) is determined as the deflection length,

the load bearing dent is measured in a condition in which

(1) a 100 mm square sample is collected,
(2) the sample is placed on a glass plate with a thickness of 20 mm, a 0.5 g steel ball with a diameter of 5 mm is added on the central part of the sample, and a 2 kg load is further added on the steel ball, and
(3) the dent "d" in the sample (unit: $\mu$m) is measured, and the ratio "d/t" of the dent "d" to the thickness "t" (unit:$\mu$m) of the sample is determined as the load bearing dent.

**11.** The roll-shaped article according to claim 10, wherein the conditions (a') and/or (b') are satisfied,
the condition (a') is deflection length of cover sheet / deflection length of fluorine-based resin film $\leq$ 2, and
the condition (b') is load bearing dent of cover sheet / load bearing dent of fluorine-based resin film $\leq$ 2.

**12.** A method of producing a solar cell protective material comprising the steps of:

(1) forming a laminate X having a pressure sensitive adhesive layer on a moisture-resistant film,
(2) slitting both the ends in the width direction of the laminate X to form a laminate X', and
(3) attaching a fluorine-based resin film having a width $W_A$ being more than the width $W_{X'}$ of the laminate X' to the pressure sensitive adhesive layer so that both the ends of the fluorine-based resin film project from the respectively corresponding ends of the pressure sensitive adhesive layer.

**13.** The method according to claim 12, wherein a laminate X further having a release sheet 1 is formed on the pressure sensitive adhesive layer in the step (1), and the release sheet 1 is peeled off after the step (2) and before the fluorine-based resin film is attached.

**14.** The method according to claim 13, wherein, in the step (1) , a pressure sensitive adhesive layer composition is applied to a release sheet 1 and dried to form a pressure sensitive adhesive layer, and then a moisture-resistant film is attached to the pressure sensitive adhesive layer to form a laminate X.

**15.** A solar cell module formed by using the solar cell protective material according to any one of claims 1 to 6 or the encapsulating material-integrated protective material according to claim 7 or 8.

Fig. 1

Fig. 2

Vacuum lamination

Fig. 3

Fig. 4

Fig. 5

Step (1)

Step (2)

Step (3)

Fig. 6

Narrow depressed part

1
21
3
} 10

| | | International application No. |
|---|---|---|
| **INTERNATIONAL SEARCH REPORT** | | PCT/JP2012/083997 |

**A.    CLASSIFICATION OF SUBJECT MATTER**
*H01L31/042*(2006.01)i, *B32B27/00*(2006.01)i

According to International Patent Classification (IPC) or to both national classification and IPC

**B.    FIELDS SEARCHED**

Minimum documentation searched (classification system followed by classification symbols)
H01L31/042, B32B27/00

Documentation searched other than minimum documentation to the extent that such documents are included in the fields searched
Jitsuyo Shinan Koho        1922-1996    Jitsuyo Shinan Toroku Koho    1996-2013
Kokai Jitsuyo Shinan Koho    1971-2013    Toroku Jitsuyo Shinan Koho    1994-2013

Electronic data base consulted during the international search (name of data base and, where practicable, search terms used)

**C.    DOCUMENTS CONSIDERED TO BE RELEVANT**

| Category* | Citation of document, with indication, where appropriate, of the relevant passages | Relevant to claim No. |
|---|---|---|
| A | JP 7-142756 A  (Canon Inc.), 02 June 1995 (02.06.1995), entire text; all drawings & US 5707459 A        & EP 631328 A1 | 1-15 |
| A | JP 6-85300 A  (Canon Inc.), 25 March 1994 (25.03.1994), entire text; all drawings (Family: none) | 1-15 |
| A | WO 2010/150692 A1  (Toray Engineering Co., Ltd.), 29 December 2010 (29.12.2010), entire text; all drawings & TW 201101517 A | 1-15 |

☐   Further documents are listed in the continuation of Box C.        ☐   See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 25 January, 2013 (25.01.13) | 05 February, 2013 (05.02.13) |

| Name and mailing address of the ISA/ | Authorized officer |
|---|---|
| Japanese Patent Office | |
| Facsimile No. | Telephone No. |

Form PCT/ISA/210 (second sheet) (July 2009)

**EP 2 800 149 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2007150084 A
- JP 2009188072 A
- JP 2009049252 A